# EUROPEAN PATENT SPECIFICATION

(11) **EP 1 271 581 B1**
(45) Date of publication and mention of the grant of the patent: **11.10.2006**
(21) Application number: 02012562.1
(22) Date of filing: 05.06.2002
(51) Int. Cl.: H01G 9/20, C07D 233/60, C07D 233/54

(54) **Electrolyte composition, photoelectric conversion device and photo-electrochemical cell**
Elektrolytezusammensetzung, photoelektrische Umwandlungsvorrichtung und photoelektrochemische Zelle
Composition d'électrolyte, dispositif de conversion photoélectrique et cellule photoélectrochimique

(30) Priority: 05.06.2001 JP 2001170042
(43) Date of publication of application: 02.01.2003
(73) Proprietor: FUJI PHOTO FILM CO., LTD., Minami-Ashigara-shi, Kanagawa-ken (JP)
(72) Inventor: Watanabe, Tetsuya, Minami-Ashigara-shi, Kanagawa-ken (JP)
(74) Representative: Solf, Alexander

(56) References cited:
- EP-A- 1 089 305
- US-A- 4 581 370
- PAPAGEORGIOU N ET AL: "The Performance and Stability of Ambient Temperature Molten Salts for Solar Cell Applications" JOURNAL OF THE ELECTROCHEMICAL SOCIETY, ELECTROCHEMICAL SOCIETY. MANCHESTER, NEW HAMPSHIRE, US, vol. 143, no. 10, October 1996 (1996-10), pages 3099-3108, XP002118482 ISSN: 0013-4651

## Description

### FIELD OF THE INVENTION

The present invention relates to an electrolytic composition excellent in durability and charge-transporting capability, a photoelectric conversion device comprising such an electrolytic composition for exhibiting high durability and excellent photoelectric conversion properties, and a photo-electrochemical cell comprising such a photoelectric conversion device.

### BACKGROUND OF THE INVENTION

Liquid electrolyte compositions (electrolyte solutions) comprising solvents and electrolyte salts dissolved therein have conventionally been used as electrolyte compositions for electrochemical devices such as cells, capacitors, sensors, display devices, recording devices, etc. However, the electrochemical devices using such liquid electrolyte compositions are unreliable because they often suffer from the leakage of liquid electrolyte compositions during long-term operation or storage.

"Nature," Vol. 353, pages 737 to 740 (1991), United States Patent 4,927,721, etc. disclose photoelectric conversion devices utilizing dye-sensitized semiconductor particles, and photo-electrochemical cells comprising them. Because the photoelectric conversion devices also comprise the electrolyte solutions in charge transfer layers, however, there is still likelihood that their photoelectric conversion efficiency is extremely lowered, or their photoelectric conversion function is lost by leakage or depletion of the electrolyte solutions during the long-term operation or storage.

Under these circumstances, WO 93/20565 discloses a photoelectric conversion device comprising a solid electrolyte. Further, Nippon Kagaku Kaishi (the Japanese Journal of Chemistry), 7, 484 (1997), JP 7-288142 A, "Solid State Ionics," 89, 263 (1986), and JP 9-27352 A propose a photoelectric conversion device using a solid electrolyte comprising a cross-linked polyethylene oxide high-molecular compound. However, the devices using the solid electrolytes are insufficient in photoelectric conversion characteristics, especially in short-circuiting current density and durability.

Disclosed in WO 95/18456, JP 8-259543 A, "Denki Kagaku (Electrochemistry)," 65, 11, 923 (1997), etc. are photoelectric conversion devices comprising electrolyte compositions in which pyridinium salts, imidazolium salt, triazolium salts, etc. are used as the electrolytes to prevent the leakage and depletion of the electrolyte compositions. The salts are in a liquid state at room temperature (around 25°C), called as "room-temperature-molten salt." In such electrolyte compositions, solvents for dissolving the electrolytes such as water and organic solvents are needed in little amounts, if necessary, whereby the photoelectric conversion devices comprising the compositions exhibit improved durability. However, in all room-temperature-molten salts used in the conventional photoelectric conversion devices cations and anions are not connected via covalent bonds, leaving cations and anions movable separately. Therefore, they are disadvantageous in the diffusion of redox couples. The devices using the room-temperature-molten salts generally have such a defect as insufficient photoelectric conversion efficiency.

EP 1 089 305 discloses an electrolyte composition comprising a compound represented by the following general formula (1) and its use for a photoelectric conversion device and a photo-electrochemical cell. 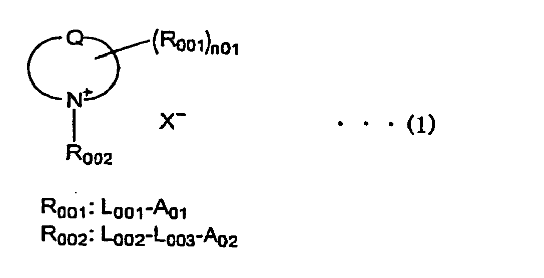 wherein:
- Q represents an atom group forming an aromatic cation having a 5- or 6-membered ring structure with a nitrogen atom;
- R₀₀₁ and R₀₀₂ represent substituents;
- n₀₁ represents an integer from 0 to the maximum member of substituent R₀₀₁ attachable to Q, i.e., in a cation having a 6-membered ring structure, n₀₁ is an integer from 0 to 5.
- X⁻ represents a counter ion ; and
- R₀₀₂ is a substituent represented by the general formula L₀₀₂-L₀₀₃-A₀₂
wherein L₀₀₂ represents a divalent group linking the aromatic cation Q to L₀₀₃; L₀₀₃ is e.g. a divalent linking group; A₀₂ represents a substituents;

### OBJECTS OF THE INVENTION

Accordingly, an object of the present invention is to provide an electrolytic composition excellent in durability and charge-transporting capability.

Another object of the present invention is to provide a photoelectric conversion device comprising such an electrolytic composition for exhibiting high durability and excellent photoelectric conversion properties.

A further object of the present invention is to provide a photo-electrochemical cell comprising such a photoelectric conversion device.

### SUMMARY OF THE INVENTION

As a result of intense research in view of the above objects, the inventor has found that an electrolytic composition comprising a zwitterionic-type organic salt and an iodine salt according to claim 1 is excellent in the durability and charge-transporting capability. The present invention has been accomplished by this finding.

The electrolytic composition of the present invention has a zwitterionic-type organic salt and an iodine salt according to claim 1. The photoelectric conversion device of the present invention has an electrically conductive layer, a photosensitive layer, a charge transfer layer and a counter electrode, wherein the charge transfer layer comprises the electrolytic composition of the present invention. The photo-electrochemical cell of the present invention comprises the photoelectric conversion device.

By satisfying the following conditions, further improvement is achieved in the durability and the charge-transporting capability of the electrolyte composition, and in the durability and the photoelectric conversion properties of the photoelectric conversion device and the photo-electrochemical cell.
(1) The zwitterionic-type organic salt is preferably liquid at room temperature.
(2) The zwitterionic-type organic salt is represented by the following general formula (I): 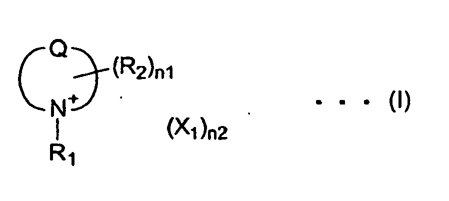
   In the above general formula (I), Q represents an atom group forming an aromatic cation having a 5- or 6-membered ring structure with a nitrogen atom; R₁ represents a hydrogen atom or a substituent; R₂ represents a substituent; n1 represents an integer of 0 to 5; X₁ represents a counter ion, n2 represents an integer of 0 to 4; a plurality of R₂ may be the same or different when n1 is 2 or more; and at least one of R₁ and R₂ is a substituent represented by the following general formula (II):

   -L₁-V₁N⁻V₂-R₃ (II).

   In the general formula (II), L₁ represents a divalent group linking the above aromatic cation to V₁; V₁ and V₂ independently represent -CO-, - SO-, -SO₂- or -PO(OR₄)-, wherein R₄ represents an alkyl group or an aryl group; and R₃ represents a substituent.
(3) The 5- or 6-membered ring formed by Q is particularly an imidazole ring or a pyridine ring, most preferably an imidazole ring.
(4) In the general formula (I), R₁ is preferably a substituent represented by the general formula (II).
(5) In the general formula (II), at least one of V₁ and V₂ is preferably - SO₂-. Particularly both of V₁ and V₂ are -SO₂-.
(6) In the general formula (I), n2 is preferably 0.
(7) The melting point of the zwitterionic-type organic salt in the general formula (I) is preferably 100°C or lower.
(8) The electrolytic composition preferably comprises a solvent of 10% by mass or less based on the entire electrolyte composition.
(9) The electrolytic composition preferably comprises iodine.
(10) The photosensitive layer of the photoelectric conversion device preferably comprises fine semiconductor particles sensitized by a dye. The fine semiconductor particles preferably comprise fine titanium oxide particles. The dye is preferably a metal complex dye and/or a polymethine dye.

In the present invention, a novel imidazolium compound represented by the following general formula (III) is preferably used as a zwitterionic-type organic salt.

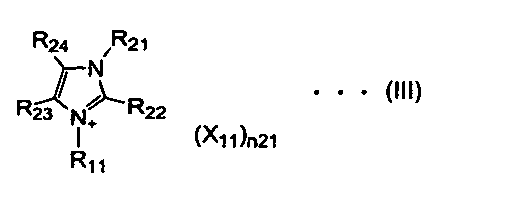

In the general formula (III), R₁₁ and R₂₁-R₂₄ independently represent a hydrogen atom or a substituent, X₁₁ represents a counter ion, and n21 represents an integer of 0 to 4. R₁₁ and R₂₁-R₂₄ may be the same or different groups, and at least one of R₁₁ and R₂₁-R₂₄ is a substituent represented by the following general formula (IV):

-L₁₁-V₁₁N⁻V₂₁-R₃₁ (IV)

In the general formula (IV), L₁₁ represents a divalent group linking the imidazolium cation in the general formula (III) to V₁₁; V₁₁ and V₂₁ represent -SO₂-; and R₃₁ represents a substituent.

### BRIEF DESCRIPTION OF THE DRAWINGS

Fig. 1 is a partial cross sectional view showing a preferable structure of the photoelectric conversion device of the present invention;
Fig. 2 is a partial cross sectional view showing another preferable structure of the photoelectric conversion device of the present invention;
Fig. 3 is a partial cross sectional view showing a further preferable structure of the photoelectric conversion device of the present invention;
Fig. 4 is a partial cross sectional view showing a still further preferable structure of the photoelectric conversion device of the present invention;
Fig. 5 is a partial cross sectional view showing a still further preferable structure of the photoelectric conversion device of the present invention;
Fig. 6 is a partial cross sectional view showing a still further preferable structure of the photoelectric conversion device of the present invention;
Fig. 7 is a partial cross sectional view showing a still further preferable structure of the photoelectric conversion device of the present invention;
Fig. 8 is a partial cross sectional view showing a still further preferable structure of the photoelectric conversion device of the present invention; and
Fig. 9 is a partial cross sectional view showing a still further preferable structure of the photoelectric conversion device of the present invention.

### DETAILED DESCRIPTION OF THE PREFERRED EMBODIMENTS

### [1] Electrolyte composition

The electrolytic composition according to the present invention comprises a zwitterionic-type organic salt and an iodine salt. The electrolytic composition may comprise iodine and a solvent, etc. When the zwitterionic-type organic salt is an iodine salt, the electrolytic composition need not contain another iodine salt. The electrolytic composition of the present invention is usable for a reaction solvent for chemical reactions, metal plating, etc., CCD (charge-coupled device) cameras, various photoelectric conversion devices and cells, etc. The composition is preferably used for lithium ion secondary batteries or photo-electrochemical cells, particularly those comprising semiconductors. The constitutive elements of the electrolytic composition will be described in detail below.

### (A) Zwitterionic-type organic salt

The zwitterionic-type organic salt used in the present invention is an organic compound having a moiety having cationic charge and a moiety having anionic charge in a molecule, both moieties being linked via a covalent bond. The zwitterionic-type organic salt used in the electrolytic composition of the present invention is preferably liquid at room temperature (around 25°C).

The zwitterionic-type organic salt is represented by the following general formula (I). The zwitterionic-type organic salt represented by the general formula (I) is called "organic salt (I)" herein. The organic salt (I) is usually a low-melting point salt, which is called "molten salt." The melting point of the organic salt (I) is preferably 100°C or lower, more preferably 80°C or lower, particularly 60°C or lower. The organic salt (I) may be a molten salt, which is liquid at room temperature (around 25°C), a so-called "room temperature-molten salt."

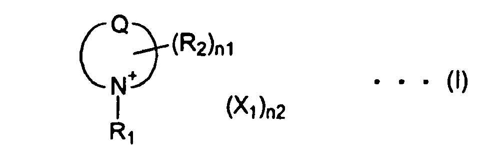

In many cases, a mixture of the organic salt (I) and the iodine salt may be used as an electrolytic composition only with a little amount of a solvent, and a solvent is not needed in some cases. When this mixture is solid at room temperature (around 25°C), a solvent and an additive, etc. can be added thereto to use as a liquid electrolyte composition. It may also be incorporated into a photoelectric conversion device without additives, by a method for melting it by heat to cause it to penetrate into an electrode, a method for causing it to penetrate into an electrode using a low-boiling point solvent such as methanol, acetonitrile, dichloromethane, etc., and then removing the a solvent by heating, etc.

In the general formula (I), Q represents an atom group forming an aromatic cation having a 5- or 6-membered ring structure with a nitrogen atom. Q is preferably composed of atoms selected from the group consisting of carbon, hydrogen, nitrogen, oxygen and sulfur atoms.

The preferred 5-membered ring formed by Q is such ring as an oxazole ring, a thiazole ring, an imidazole ring, a pyrazole ring, an iso-oxazole ring, a thiadiazole ring, an oxadiazole ring or a triazole ring. The 5-membered ring is more preferably an oxazole ring, a thiazole ring or an imidazole ring, particularly an imidazole ring. The preferred 6-membered ring formed by Q is such ring as a pyridine ring, a pyrimidine ring, a pyridazine ring, a pyrazine ring or a triazine ring. The 6-membered ring is particularly a pyridine ring. The 5- or 6-membered ring formed by Q with a nitrogen atom is most preferably an imidazole ring.

In the general formula (I), R₁ represents a hydrogen atom or a substituent; R₂ represents a substituent; and n 1 represents the number of R₂, which is an integer of 0 to 5. R₂ may be the same or different groups when n1 is 2 or more. Further, two or more of R₁ and R₂ may be bonded together to form a ring.

At least one of R₁ and R₂ is a substituent represented by the following general formula (II). The substituent represented by the general formula (II) is called "substituent (II)" hereinafter. The organic salt (I) comprises preferably one to four substituents (II), more preferably one substituent (II). In particular, R₁ is a substituent (II).

-L₁-V₁N⁻V₂-R₃ (II)

In the general formula (II), L₁ represents a divalent group linking the above aromatic cation to V₁. L₁ is preferably composed of atoms selected from the group consisting of carbon, hydrogen, nitrogen, oxygen and sulfur atoms. The number of carbon atoms of L₁ is preferably 1 to 30, more preferably 2 to 20, particularly 2 to 8. Examples of L₁ include an alkylene group, an arylene group, an alkylenoxy group, arylenoxy group, a combination thereof, etc. L₁ is more preferably an alkylene group or an alkylenoxy group each having 2 to 8 carbon atoms.

In the general formula (II), V₁ and V₂ independently represent - CO-, -SO-, -SO₂- or -PO(OR₄)-, wherein R₄ represents an alkyl group or an aryl group. At least one of V₁ and V₂ is preferably -SO₂-. Particularly both of V₁ and V₂ are -SO₂-.

In the general formula (II), R₃ represents a substituent. Preferable examples of the substituent include an alkoxy group such as a methoxy group, an ethoxy group, etc.; an alkyl group preferably having 1 to 80 carbon atoms, such as a methyl group, an ethyl group, a propyl group, a butyl group, an isopropyl group, a pentyl group, a hexyl group, an octyl group, a 2-ethylhexyl group, a *t*-octyl group, a decyl group, a dodecyl group, a tetradecyl group, a 2-hexyldecyl group, an octadecyl group, a cyclohexyl group, and a cyclopentyl group, etc.; an alkenyl group preferably having 2 to 80 carbon atoms, such as a vinyl group, an allyl group, etc.; and a perfluoroalkyl group. R₃ is more preferably an alkyl group having 3 to 60 carbon atoms or an alkenyl group having 2 to 60 carbon atoms, particularly an alkyl group having 3 to 48 carbon atoms.

When R₁ in the general formula (I) represents a substituent except for the above substituent (II), its preferable examples include an alkyl group having 1 to 80 carbon atoms, such as a methyl group, an ethyl group, a propyl group, a butyl group, an isopropyl group, a pentyl group, a hexyl group, an octyl group, a 2-ethylhexyl group, a *t*-octyl group, a decyl group, a dodecyl group, a tetradecyl group, a 2-hexyldecyl group, an octadecyl group, a cyclohexyl group, and a cyclopentyl group, etc.; and an alkenyl group preferably having 2 to 80 carbon atoms, such as a vinyl group, an allyl group, etc. The substituent is more preferably an alkyl group having 3 to 60 carbon atoms or an alkenyl group having 2 to 60 carbon atoms, particularly an alkyl group having 3 to 48 carbon atoms. R₁ may have a further substituent, which may be the same as the substituent represented by R₂ described later.

When R₂ in the general formula (I) represents a substituent except for the above substituent (II), its preferable examples include alkoxy groups such as a methoxy group, an ethoxy group, and -(OCH₂CH₂)ₙ-OCH₃, wherein n represents an integer of 1 to 20, -(OCH₂CH₂)ₙ-OCH₂CH₃, wherein n represents an integer of 1 to 20; cyano groups; alkoxycarbonyl groups such as an ethoxycarbonyl group and a methoxyethoxycarbonyl group; carbonate groups such as an ethoxycarbonyloxy group; amido groups such as an acetylamino group and an benzoylamino group; carbamoyl groups such as an *N,N*-dimethylcarbamoyl group and an *N-*phenylcarbamoyl group; phosphonyl groups such as a diethylphosphonyl group; heterocyclic groups such as a pyridyl group, an imidazolyl group, a furanyl group and a oxazolydinonyl group, aryloxy groups such as a phenoxy group; alkylthio groups such as a methylthio group and an ethylthio group; acyl groups such as an acetyl group, a propionyl group and a benzoyl group; sulfonyl groups such as a methane sulfonyl group and a benzene sulfonyl group; acyloxy groups such as an acetoxy group and a benzoyloxy group; sulfonyloxy groups such as a methane sulfonyloxy group and a toluene sulfonyloxy group; aryl groups such as a phenyl group and a tolyl group; aryloxy groups such as a phenoxy group; alkenyl groups such as a vinyl group and a 1-propenyl group; alkyl groups such as a methyl group, an ethyl group, a propyl group, an isopropyl group, a cyclopropyl group, a butyl group and a 2-carboxyethyl group; benzyl groups, etc. The substituent is more preferably an alkoxy group, a cyano group, a carbonate group, an amido group, a carbamoyl group, a phosphonyl group, a heterocyclic group, an acyl group, a sulfonyl group, an acyloxy group, a sulfonyloxy group or an alkyl group, particularly an alkoxy group, a cyano group, a carbonate group, a phosphonyl group, a heterocyclic group or an alkyl group.

In the general formula (I), X₁ is a counter ion, and n2 is the number of X₁, which is an integer of 0 to 4. n2 is selected such that the charge of the entire organic salt (I) is neutralized. When a portion of the organic salt (I) excluding X₁ is cationic or anionic or when it has net charge, depending on the properties of the substituent in the organic salt (I), a counter ion X₁ is necessary. When the organic salt (I) contains a dissociating group capable of having negative charge, the charge of the entire organic salt (I) is also neutralized by X₁. Typical examples of a positive counter ion represented by X₁ include inorganic or organic ammonium ions such as tetralkyl ammonium ions and pyridinium ions; alkali metal ions; etc. A negative counter ion represented by X₁ may be inorganic or organic, exemplified by halide ions such as a fluoride ion, a chloride ion, a bromide ion and an iodide ion; substituted aryl sulfonate ions such as a *p*-toluene sulfonate ion and a *p*-chlorobenzene sulfonate ion; aryl disulfonate ions such as a 1,3-benzene disulfonate ion, a 1,5-naphthalene disulfonate ion and a 2,6-naphthalene disulfonate ion; alkyl sulfate ions such as a methyl sulfate ion; a sulfate ion; a thiocyanate ion; a perchlorate ion; a tetrafluoroborate ion; a hexafluorophosphate ion; a picrate ion; an acetate ion; a trifluoromethane sulfonate ion; etc. Further, X₁ may be a charge-balancing counter ion such as an ionic polymer or a metal complex ion such as bisbenzene-1,2-dithiolato nickel (III). It is preferable that n2 is 0, and that the organic salt (I) does not contain X₁. It is also preferable that there is no counter ion that is not linked to the organic salt (I) via a covalent bond.

The organic salt (I) may form a polymer via R₁ or R₂. This polymer is preferably a dimer to tetramer, more preferably a dimer. Further, when the organic salt (I) comprises an alkyl group, an alkenyl group, an alkynyl group, an alkylene group, an aralkyl group etc., these groups may be straight, branched or cyclic which may be substituted or unsubstituted. When the organic salt (I) comprises an aryl group, a heterocyclic group, a cycloalkyl group, an aralkyl group, etc., these groups may have a monocyclic structure or a polycyclic structure such as a condensed ring and a ring assemblage, which may be substituted or unsubstituted.

In the present invention, a novel imidazolium compound represented by the following general formula (III) can be preferably used as the organic salt (I). The imidazolium compound represented by the general formula (III) is called "compound (III)" hereinafter.

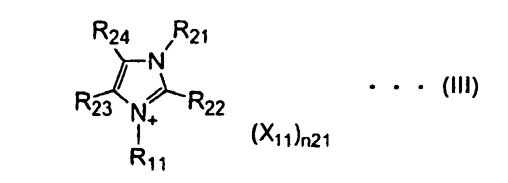

In the general formula (III), R₁₁ and R₂₁-R₂₄ independently represent a hydrogen atom or a substituent. R₁₁ and R₂₁-R₂₄ may be the same or different groups. Further, two or more of R₁₁ and R₂₁-R₂₄ may be bonded together to form a ring.

At least one of R₁₁ and R₂₁-R₂₄ is a substituent represented by the following general formula (IV). The substituent represented by the general formula (IV) is called "substituent (IV)" hereinafter. The general formula (III) preferably comprises one to four substituents (IV), more preferably one substituent (IV). At least one of R₁₁ and R₂₁ is particularly a substituent (IV).

-L₁₁-V₁₁N⁻V₂₁-R₃₁ (IV)

In the general formula (IV), L₁₁ represents a divalent group linking an imidazolium cation in the above general formula (III) to V₁₁. Preferred examples of L₁₁ are the same as those of L₁ in the general formula (II). Both V₁₁ and V₂₁ represent -SO₂-. R₃₁ may be the same as R₃ in the general formula (II).

When R₁₁ and R₂₁ in the general formula (III) represent other substituents than the above substituent (IV), their preferred examples are the same as R₁ in the above general formula (I). When R₂₂-R₂₄ represent other substituents than the above substituent (IV), their preferred examples are the same as R₂ in the above the general formula (I). X₁₁ represents a counter ion, and n21 indicating the number of X₁₁is an integer of 0-4. X₁₁ and n21 may be the same as X₁ and n2 in the above the general formula (I).

The compound (III) may form a polymer via either of R₁₁ and R₂₁₋R₂₄. This polymer is preferably a dimer to a tetramer, more preferably a dimer.

The content of the zwitterionic-type organic salt in the electrolytic composition of the present invention is preferably 10% by mass or more, more preferably 20-95% by mass, based on the entire electrolyte composition. Specific examples of the zwitterionic-type organic salt will be shown without limitation.

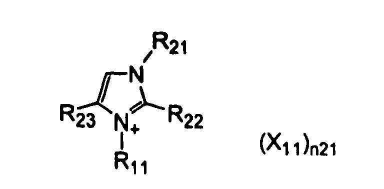

| | R₁₁ | R₂₁ | R₂₂ | R₂₃ | (X₁₁)ₙ₂₁ |
|---|---|---|---|---|---|
| D-1 | -(CH₂)₃SO₂N⁻SO₂CF₃ | -CH₃ | H | H | - |
| D-2 | -(CH₂)₂O(CH₂)₂O(CH₂)₂SO₂N⁻SO₂CF₃ | -CH₃ | H | H | ― |
| D-3 | -(CH₂)₂O(CH₂)₂O(CH₂)₂SO₂N⁻SO₂CF₃ | -CH₂CH₂OCH₃ | H | H | ― |
| D-4 | -(CH₂)₂CON⁻SO₂CF₃ | -C₂H₅ | H | H | ― |
| D-5 | -(CH₂)₃PO₂N⁻SO₂CF₃ | -C₂H₅ | H | H | ― |
| D-6 | -(CH₂)₂SON⁻SO₂CF₃ | -C₂H₅ | H | H | ― |
| D-7 | -(CH₂)₂CON⁻COCF₃ | -C₂H₅ | H | H | ― |
| D-8 | -(CH₂)₃SO₂N⁻SO₂CH₃ | -C₂H₅ | H | H | ― |
| D-9 | -(CH₂)₂O(CH₂)₂O(CH₂)₂SO₂N⁻SO₂CF₃ | -(CH₂)₃SO₃⁻ | H | H | N⁺(CH₂CH₂CH₃)₄ |
| D-10 | -(CH₂)₂O(CH₂)₂OCH₃ | -C₂H₅ | H | -(CH₂)₃SO₂N⁻SO₂CF₃ | ― |
| D-11 | -(CH₂)₂O(CH₂)₂OCH₃ | -C₂H₅ | -(CH₂)₃SO₂N⁻SO₂CF₃ | H | ― |

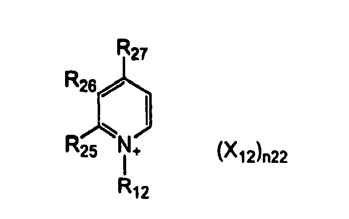

| | R₁₂ | R₂₅ | R₂₆ | R₂₇ | (X₁₂)ₙ₂₂ |
|---|---|---|---|---|---|
| D-12 | -(CH₂)₃SO₂N⁻SO₂CF₃ | H | H | H | - |
| D-13 | -(CH₂)₂SO₂N⁻COCF₃ | H | H | H | - |
| D-14 | -(CH₂)₂OCH₃ | -(CH₂)₃SO₂N⁻SO₂CF₃ | H | H | - |
| D-15 | -(CH₂)₂OCH₃ | H | H | -(CH₂)₃SO₂N⁻SO₂CF₃ | - |
| D-16 | -(CH₂)₂OCH₃ | H | -(CH₂)₃SO₂N⁻SO₂CF₃ | H | - |
| D-17 | -(CH₂)₂O(CH₂)₂OSO₂N⁻COCF₃ | CH₃ | H | H | - |
| D-18 | -(CH₂)₃SO₂N⁻SO₂CF₃ | H | H | -O(CH₂)₃SO₂N⁻SO₂CF₃ | N⁺(CH₂CH₂CH₂CH₃)₄ |

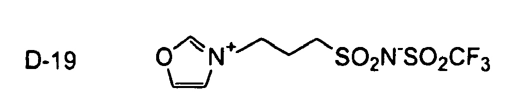

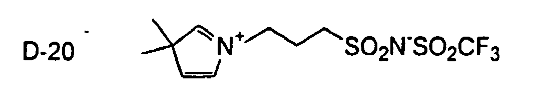

### (B) Iodine salt

The electrolytic composition of the present invention comprises a zwitterionic-type organic salt and an iodine salt. When the above zwitterionic-type organic salt is not an iodine salt, it is necessary to add another iodine salt to the electrolyte composition. Such iodine salts include pyridinium salts, imidazolium salts and triazolium salts disclosed in WO 95/18456, JP 8-259543 A, "Denki Kagaku (Electrochemistry)," 65, 11, 923 (1997), etc. The electrolytic composition of the present invention may further comprise another salt in addition to the zwitterionic-type organic salt and an iodine salt. The iodine salt content in the electrolytic composition of the present invention is preferably 10% by mass or more, more preferably 50 to 95% by mass, based on the entire electrolyte composition.

The preferred iodine salt used in the electrolytic composition of the present invention is represented by any of the following general formulae (Y-a), (Y-b) and (Y-c):

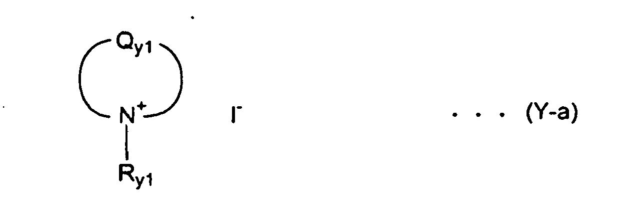

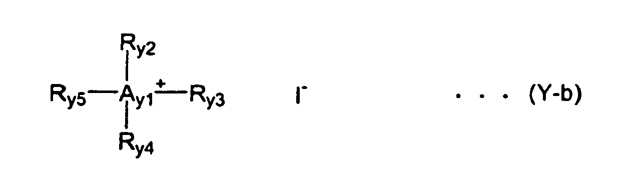

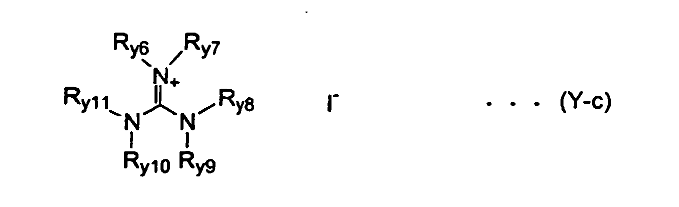

In the general formula (Y-a), Q_{y1} represents an atom group forming an aromatic cation having a 5- or 6-membered ring structure with a nitrogen atom. Q_{y1} is preferably composed of atoms selected from the group consisting of carbon, hydrogen, nitrogen, oxygen and sulfur atoms. The preferred 5-membered ring formed by Q_{y1} is such ring as an oxazole ring, a thiazole ring, an imidazole ring, a pyrazole ring, an iso-oxazole ring, a thiadiazole ring, an oxadiazole ring or a triazole ring. The 5-membered ring is more preferably an oxazole ring, a thiazole ring or an imidazole ring, particularly an oxazole ring or an imidazole ring. The preferred 6-membered ring formed by Q_{y1} is such ring as a pyridine ring, a pyrimidine ring, a pyridazine ring, a pyrazine ring or a triazine ring. The 6-membered ring is more preferably a pyridine ring.

In the general formula (Y-b), A_{y1} represents a nitrogen atom or a phosphorus atom.

R_{y1} to R_{y11} in the general formulae (Y-a), (Y-b) and (Y-c) independently represent a substituted or unsubstituted alkyl group preferably having 1 to 24 carbon atoms, which may be straight, branched or cyclic, such as a methyl group, an ethyl group, a propyl group, an isopropyl group, a pentyl group, a hexyl group, an octyl group, a 2-ethylhexyl group, a *t*-octyl group, a decyl group, a dodecyl group, a tetradecyl group, a 2-hexyldecyl group, an octadecyl group, a cyclohexyl group, a cyclopentyl group, etc.; or a substituted or unsubstituted alkenyl group preferably having 2 to 24 carbon atoms, which may be straight or branched, such as a vinyl group, an allyl group, etc. R_{y1} to R_{y11} are more preferably an alkyl group having 2 to 18 carbon atoms or an alkenyl group having 2 to 18 carbon atoms, particularly an alkyl group having 2 to 6 carbon atoms, independently.

Two or more of R_{y2} to R_{y5} in the general formula (Y-b) may be bonded together to form a non-aromatic ring containing A_{y1}. Two or more of R_{y6} to R_{y11} in the general formula (Y-c) may be bonded together to form a ring.

Q_{y1} and R_{y1} to R_{yn} may have substituents. Preferable examples of the substituents include halogen atoms such as F, Cl, Br and I; cyano groups; alkoxy groups such as a methoxy group and an ethoxy group; aryloxy groups such as a phenoxy group; alkylthio groups such as a methylthio group and an ethylthio group; alkoxycarbonyl groups such as an ethoxycarbonyl group; carbonate groups such as an ethoxycarbonyloxy group; acyl groups such as an acetyl group, a propionyl group and a benzoyl group; sulfonyl groups such as a methane sulfonyl group and a benzene sulfonyl group; acyloxy groups such as an acetoxy group and a benzoyloxy group; sulfonyloxy groups such as a methane sulfonyloxy group and a toluene sulfonyloxy group; phosphonyl groups such as a diethylphosphonyl group; amido groups such as an acetylamino group and an benzoylamino group; carbamoyl groups such as an *N,N*-dimethylcarbamoyl group; alkyl groups such as a methyl group, an ethyl group, a propyl group, an isopropyl group, a cyclopropyl group, a butyl group, a 2-carboxyethyl group and a benzyl group; aryl groups such as a phenyl group and a tolyl group; heterocyclic groups such as a pyridyl group, an imidazolyl group and a furanyl group; alkenyl groups such as a vinyl group and a 1-propenyl group, etc.

The iodine salt represented by the general formula (Y-a), (Y-b) or (Y-c) may form an oligomer (polymer) via Q_{y1} or R_{y1} to R_{y11}.

### (C) Iodine

The electrolytic composition of the present invention preferably comprises iodine. Particularly, when the electrolytic composition is used in a photoelectric conversion device, the addition of iodine is highly effective. Iodine added to the electrolytic composition may exist in the form of I₂, an ion or a salt therein. When iodine is added to the electrolytic composition of the present invention, the amount of iodine is preferably 0.1 to 20% by mass, more preferably 0.5 to 5% by mass, based on the entire electrolyte composition.

### (D) Solvent

The electrolytic composition of the present invention may comprise a solvent. The solvent content in the electrolytic composition is preferably 50% by mass or less, more preferably 30% by mass or less, particularly 10% by mass or less, based on the entire electrolyte composition.

Preferably used in the present invention is a solvent having excellent ion conductibility because of low viscosity and high ion mobility, and/or high dielectric constant and effective carrier concentration. Examples of such solvents include carbonates such as ethylene carbonate and propylene carbonate; heterocyclic compounds such as 3-methyl-2-oxazolidinone; ethers such as dioxan and diethyl ether; chain ethers such as ethyleneglycol monoalkylethers, ethyleneglycol dialkylethers, propyleneglycol monoalkylethers, propyleneglycol dialkylethers, polyethyleneglycol monoalkylethers, polyethyleneglycol dialkylethers, polypropyleneglycol monoalkylethers and polypropyleneglycol dialkylethers; alcohols such as methanol and ethanol; glycols such as ethylene glycol, propylene glycol, polyethylene glycol, polypropylene glycol and glycerin; nitriles such as acetonitrile, glutarodinitrile, methoxyacetonitrile, propionitrile, benzonitrile and biscyanoethyl ether; esters such as carboxylates, phosphates and phosphonates; aprotic polar solvents such as dimethylsulfoxide (DMSO) and sulfolane; water; etc. Two or more of these solvents may be mixed together.

### (E) Others

The electrolytic composition of the present invention may be used in the form of a gel or a solid, which is obtained by adding a polymer or an oil-gelling agent, by polymerization together with multifunctional monomers or by a cross-linking reaction, etc.

In the case of gelling the electrolytic composition by adding a polymer, polymers described in "Polymer Electrolyte Reviews-1 and 2", edited by J. R. MacCallum and C. A. Vincent, ELSEIVER APPLIED SCIENCE may be used. Polyacrylonitrile or polyvinylidene fluoride is preferably used.

In the case of gelling the electrolytic composition by adding an oil-gelling agent, the oil-gelling agents described in J. Chem. Soc. Japan, Ind. Chem. Soc., 46, 779 (1943), J. Am. Chem. Soc., 111, 5542 (1989), J. Chem. Soc., Chem. Commun., 390 (1993), Angew. Chem. Int. Ed. Engl., 35, 1949 (1996), Chem. Lett., 885 (1996), J. Chem. Soc., Chem. Commun., 545 (1997), etc. may be used. Preferable among them are those having an amide structure.

When a gel electrolytic composition is formed by the polymerization of a multifunctional monomer, it is preferable to prepare a solution comprising a multifunctional monomer, a polymerization initiator, the electrolytic composition and a solvent, and form a sol electrolyte layer on a photosensitive layer by casting, coating, soaking, impregnation, etc., and then radical-polymerize the multifunctional monomer. The multifunctional monomer preferably has two or more ethylenycally unsaturated groups. Preferable examples thereof include divinyl benzene, ethyleneglycol diacrylate, ethyleneglycol dimethacrylate, diethyleneglycol diacrylate, diethyleneglycol dimethacrylate, triethyleneglycol diacrylate, triethyleneglycol dimethacrylate, pentaerythritol triacrylate and trimethylolpropane triacrylate.

The gel electrolytic composition may be formed by polymerizing a mixture of a multifunctional monomer and a monofunctional monomer. Preferable examples of the unifunctional monomers include acrylic acids and α-alkylacrylic acids (e.g. acrylic acid, methacrylic acid, itaconic acid, etc.), and esters or amides derived therefrom (e.g. *N-i*-propyl acrylamide, *N-n*-butyl acrylamide, *N-t*-butyl acrylamide, *N,N*-dimethyl acrylamide, *N-*methylmethacrylamide, acrylamide, 2-acrylamide-2-methylpropane sulfonic acid, acrylamidopropyltrimethyl ammonium chloride, methacrylamide, diacetone acrylamide, *N*-methylol acrylamide, *N-*methylolmethacrylamide, methyl acrylate, ethyl acrylate, hydroxyethyl acrylate, *n*-propyl acrylate, *i*-propyl acrylate, 2-hydroxypropyl acrylate, 2-methyl-2-nitropropyl acrylate, *n*-butyl acrylate, *i*-butyl acrylate, *t*-butyl acrylate, *t*-pentyl acrylate, 2-methoxyethyl acrylate, 2-ethoxyethyl acrylate, 2-methoxyethoxyethyl acrylate, 2,2,2-trifluoroethyl acrylate, 2,2-dimethylbutyl acrylate, 3-methoxybutyl acrylate, ethylcarbitol acrylate, phenoxyethyl acrylate, *n*-pentyl acrylate, 3-pentyl acrylate, octafluoropentyl acrylate, *n*-hexyl acrylate, cyclohexyl acrylate, cyclopentyl acrylate, cetyl acrylate, benzyl acrylate, *n*-octyl acrylate, 2-ethylhexyl acrylate, 4-methyl-2-propylpentyl acrylate, heptadecafluorodecyl acrylate, *n*-octadecyl acrylate, methyl methacrylate, 2-methoxyethoxyethyl methacrylate, ethyleneglycol ethyl carbonate methacrylate, 2,2,2-trifluoroethyl methacrylate, tetrafluoropropyl methacrylate, hexafluoropropyl methacrylate, hydroxyethyl methacrylate, 2-hydroxypropyl methacrylate, *n*-butyl methacrylate, *i*-butyl methacrylate, *t*-butyl methacrylate, *t*-pentyl methacrylate, 2-methoxyethyl methacrylate, 2-ethoxyethyl methacrylate, benzyl methacrylate, heptadecafluorodecyl methacrylate, *n*-octadecyl methacrylate, 2-isobornyl methacrylate, 2-norbornylmethyl methacrylate, 5-norbornen-2-ylmethyl methacrylate, 3-methyl-2-norbornylmethyl methacrylate, dimethylaminoethyl methacrylate, etc.); vinyl esters (e.g. vinyl acetate, etc.); maleic acid and fumaric acid, and esters derived therefrom (e.g. dimethyl maleate, dibutyl maleate, diethyl fumarate, etc.); sodium *p*-styrenesulfonate; acrylonitrile and methacrylonitrile; dienes (e.g. butadiene, cyclopentadiene, isoprene, etc.); aromatic vinyl compounds (e.g. styrene, *p*-chlorostyrene, *t*-butylstyrene, α-methylstyrene, sodium styrenesulfonate, etc.); *N*-vinylformamide, *N*-vinyl-*N*-methylformamide, *N*-vinylacetamide, and *N*-vinyl-*N*-methylacetamide; vinyl sulfonic acid; sodium vinylsulfonate, sodium allylsulfonate and sodium methacrylsulfonate; vinylidene fluoride and vinylidene chloride; vinyl alkyl ethers (e.g. methyl vinyl ether, etc.); ethylene, propylene, 1-butene and isobutene; and *N*-phenyl maleimide.

The amount of the multifunctional monomer in all the monomers is preferably 0.5 to 70% by mass, more preferably 1.0 to 50% by mass.

The above-described monomers can be polymerized by a usual radical polymerization method described in Takayuki Otsu and Masaetsu Kinoshita, "Experiment Method of Polymer Synthesis" issued by Kagaku Dojin, Takayuki Otsu, "Theory of Polymerization Reaction 1, Radical Polymerization (I)" issued by Kagaku Dojin, etc. The radical polymerization may be carried out by a heating method, a light- or electron beam- irradiation method, or an electrochemical method. Preferable among them is heat polymerization. Preferable examples of the polymerization initiators used in the present invention include azo initiators such as 2,2'-azobis(isobutyronitrile), 2,2'-azobis(2,4-dimethylvaleronitrile), dimethyl 2,2'-azobis(2-methylpropionate) and dimethyl 2,2'-azobis(isobutyate); peroxide initiators such as lauryl peroxide, benzoyl peroxide and *t*-butyl peroctoate; etc. The amount of the initiator in all the monomers is preferably 0.01 to 20% by mass, more preferably 0.1 to 10% by mass.

The weight ratio of the monomers accounting for the gel electrolytic composition is preferably in the range of 0.5 to 70% by mass, more preferably 1.0 to 50% by mass.

When the gelation of the electrolytic composition is accomplished by the cross-linking reaction of a polymer, a polymer containing a group having cross-linking reactivity is preferably added to the composition together with a cross-linking agent. Groups having cross-linking reactivity are preferably nitrogen-containing heterocyclic groups such as a pyridyl group, an imidazolyl group, a thiazolyl group, an oxazolyl group, a triazolyl group, a morpholyl group, a piperidyl group, a piperazyl group, etc. A preferred cross-linking agent is an electrophilic agent having a plurality of functional groups that can be attacked by a nitrogen atom, for example, multi-functional alkyl halides, aralkyl halides, sulfonates, acid anhydrides, acyl chlorides and isocyanates.

The electrolytic composition of the present invention may comprise a metal iodide such as LiI, NaI, KI, CsI and CaI₂; a metal bromide such as LiBr, NaBr, KBr, CsBr and CaBr₂; a quaternary ammonium bromide such as a tetralkylammonium bromide and pyridinium bromide; a metal complex such as a ferrocyanide-ferricyanide and a ferrocene-ferricinium ion; a sulfur compound such as sodium polysulfide and alkylthiol-alkyldisulfide; a viologen dye; hydroquinone-quinone; etc. These compounds may be used in combination.

The electrolytic composition of the present invention may further comprise a basic compound such as *t*-butylpyridine, 2-picoline, 2,6-lutidine, etc. described in J. Am. Ceram. Soc., 80, (12), 3157-3171 (1997). The concentration of the basic compound is preferably 0.05 to 2 M based on the electrolyte composition.

### [2] Photoelectric conversion device

The photoelectric conversion device of the present invention has an electrically conductive layer, a photosensitive layer, a charge transfer layer and a counter electrode. The charge transfer layer comprises the above-mentioned electrolytic composition of the present invention.

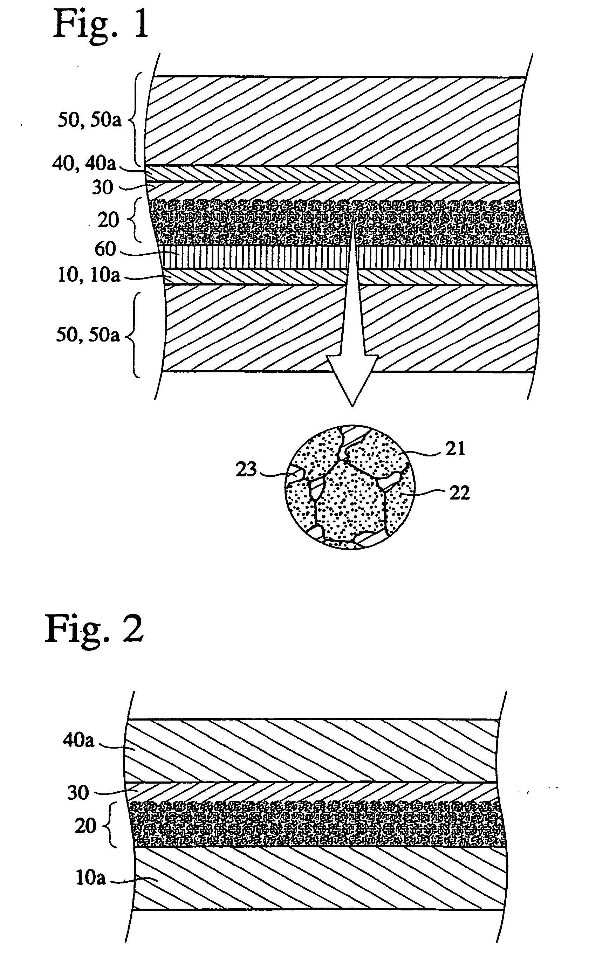

As shown in Fig. 1, the photoelectric conversion device preferably has a lamination structure comprising an electrically conductive layer 10, an undercoating layer 60, a photosensitive layer 20 comprising fine semiconductor particles 21 sensitized by a dye 22 and an charge-transporting material 23 penetrating into voids among the fine semiconductor particles 21, a charge transfer layer 30, and a counter electrode layer 40 in this order. The charge-transporting material 23 is preferably the same as the electrolytic composition used in the charge transfer layer 30. The electrically conductive layer 10 and/or the counter electrode layer 40 may be supported by a substrate 50 to improve the strength of the photoelectric conversion device. A layer composed of the electrically conductive layer 10 and the substrate 50 optionally used for supporting it is referred to as "conductive support," and a layer composed of the counter electrode layer 40 and the substrate 50 optionally used for supporting it is referred to as "counter electrode" hereinafter. The electrically conductive layer 10, the counter electrode layer 40 and the substrate 50 shown in Fig. 1 may be transparent.

In the case of using fine *n*-type semiconductor particles in the photoelectric conversion device of the present invention shown in Fig. 1, a light injected to the photosensitive layer 20 excites the dye 22, etc. to generate excited high-energy electrons, which are transported to a conduction band of the fine semiconductor particles 21, and are diffused to reach the electrically conductive layer 10. At this time, the dye 22 is in an oxidized form. In a photo-electrochemical cell, electrons in the electrically conductive layer 10 return to the oxidized dye through the counter electrode layer 40 and the charge transfer layer 30 while doing job in an outside circuit, so that the dye 22 is regenerated. The photosensitive layer 20 acts as a negative electrode (photo-anode). The counter electrode layer 40 acts as a positive electrode. In a boundary of adjacent layers such as the electrically conductive layer 10 and the photosensitive layer 20; the photosensitive layer 20 and the charge transfer layer 30; and the charge transfer layer 30 and the counter electrode layer 40, etc., components of each layer may be diffused and mixed. Each of the layers will be explained in detail below.

### (A) Conductive support

The conductive support is: (1) a single layer of the electrically conductive layer; or (2) two layers of the electrically conductive layer and the substrate. In the case (1), the electrically conductive layer is preferably made of a material having such a sufficient strength that it can fully seal the photoelectric conversion device, for example, a metal such as platinum, gold, silver, copper, zinc, titanium, aluminum and an alloy thereof. In the case (2), a substrate having the electrically conductive layer containing an electrically conductive material formed on the photosensitive layer side may be used. Preferable examples of the electrically conductive materials include metals such as platinum, gold, silver, copper, zinc, titanium, aluminum, indium and alloys thereof; carbon; electrically conductive metal oxides such as indium-tin composite oxides and tin oxides doped with fluorine or antimony; etc. The electrically conductive layer preferably has a thickness of 0.02 to 10 µm.

The surface resistance of the conductive support is desirably as low as possible. The surface resistance of the conductive support is preferably 50 Ω/square or less, more preferably 20 Ω/square or less

When light is irradiated from the conductive support side, it is preferable that the conductive support is substantially transparent. The term "substantially transparent" used herein means that 10 % or more of light transmittance is obtained in part or all of a range from a visible light to a near infrared light (400-1200 nm). The light transmittance is preferably 50 % or more, more preferably 80 % or more. In particular, light transmittance is preferably high in a wavelength range in which the photosensitive layer has sensitivity.

The transparent conductive support is preferably provided by forming the transparent electrically conductive layer comprising an electrically conductive metal oxide on the transparent substrate of such material as a glass and a plastic by coating or vapor deposition. The transparent electrically conductive layer is preferably made of tin dioxide doped with fluorine or antimony, or indium-tin oxide (ITO). The transparent substrate may be made of glass such as low-cost soda glass excellent in strength and non-alkali glass suffering from no alkaline elution. In addition, a transparent polymer film may also be used as the transparent substrate. Materials usable for the transparent polymer film are triacetylcellulose (TAC), polyethylene terephthalate (PET), polyethylene naphthalate (PEN), syndiotactic polystyrene (SPS), polyphenylenesulfide (PPS), polycarbonate (PC), polyarylate (PAr), polysulfone (PSF), polyestersulfone (PES), polyimide (PI), polyetherimide (PEI), cyclic polyolefin, a brominated phenoxy resin, etc. To secure sufficient transparency, the amount of the electrically conductive metal oxide coated is preferably 0.01 to 100 g per 1 m² of the glass or plastic substrate.

It is preferable to use a metal lead to reduce the resistance of the transparent conductive support. The metal lead is preferably made of a metal such as platinum, gold, nickel, titanium, aluminum, copper, silver, etc. The metal lead is preferably formed on the transparent substrate by a vapor deposition method, a sputtering method, etc., preferably with a transparent electrically conductive layer comprising conductive tin oxide or ITO formed thereon. Decrease in incident light quantity by the metal lead is suppressed to preferably 10 % or less, more preferably 1 to 5 %.

### (B) Photosensitive layer

The photosensitive layer comprises fine semiconductor particles sensitized by a dye. In the photosensitive layer, the fine semiconductor particles act as a photosensitive substance to absorb light and conduct charge separation, thereby generating electrons and positive holes. In the dye-sensitized, fine semiconductor particles, the light absorption and the generation of electrons and positive holes are primarily caused by the dye, and the fine semiconductor particles receive and convey electrons or positive holes. The semiconductor used in the present invention is preferably an n-type semiconductor, in which conductor electrons act as carriers under a photo-excitation condition to generate anode current.

### (1) Fine semiconductor particles

Usable as the fine semiconductor particles are simple semiconductors such as silicone and germanium; III-V compound semiconductors; metal chalcogenides such as oxides, sulfides and selenides; compounds having a perovskite structure such as strontium titanate, calcium titanate, sodium titanate, barium titanate and potassium niobate; etc.

Preferable examples of the metal chalcogenides include oxides of titanium, tin, zinc, iron, tungsten, zirconium, hafnium, strontium, indium, cerium, yttrium, lanthanum, vanadium, niobium or tantalum; sulfides of cadmium, zinc, lead, silver, antimony or bismuth; selenides of cadmium or lead; cadmium telluride; etc. Additionally, compound semiconductors such as phosphides of zinc, gallium, indium or cadmium, selenides of gallium-arsenic or copper-indium, copper-indium sulfide, etc. may be used in the present invention. Further, composite semiconductors such as MₓO_{y}S_{z} and M₁ₓM_{2y}O_{z} are also preferably used in the present invention, wherein M, M₁ and M₂ independently represent a metal atom, O represents an oxygen atom, and x, y and z represent numbers combined with each other to form a neutral molecule.

Specific examples of the semiconductors are preferably Si, TiO₂, SnO₂, Fe₂O₃, WO₃; ZnO, Nb₂O₅, CdS, ZnS, PbS, Bi₂S₃, CdSe, CdTe, SrTiO₃, GaP, InP, GaAs, CuInS₂ and CuInSe₂, more preferably TiO₂, ZnO, SnO₂, Fe₂O₃, WO₃, Nb₂O₅, CdS, PbS, CdSe, SrTiO₃, InP, GaAs, CuInS₂ and CuInSe₂, further preferably TiO₂ and Nb₂O₅, and particularly TiO₂. Preferable TiO₂ contains 70% by volume or more, particularly 100% by volume, of an anatase-type crystal structure. The semiconductor is preferably doped with a metal to increase electron conductivity thereof. This metal is preferably divalent or trivalent. Further, the semiconductor is preferably doped with a monovalent metal to prevent a reverse current from the semiconductor to the charge transfer layer.

The semiconductor used in the present invention may have a monocrystalline or polycrystalline structure. From the viewpoint of production cost, stable supply of raw materials, energy-payback time, etc., it is preferably polycrystalline, particularly a porous layer of fine semiconductor particles. The photosensitive layer may partly contain an amorphous semiconductor.

The particle size of the fine semiconductor particles is generally on the level of nm to µm. The average size of primary semiconductor particles, which is determined by averaging diameters of circles equivalent to projected areas thereof, is preferably 5 to 200 nm, more preferably 8 to 100 nm. Further, the average size of secondary semiconductor particles in dispersion is preferably 0.01 to 30 µm. Two or more of the fine semiconductor particles having different particle size distributions may be used in combination for the photosensitive layer. In this case, the average particle size of the smaller particles is preferably 25 nm or less, more preferably 10 nm or less. To improve a light-capturing rate of the photoelectric conversion device by scattering ray of incident light, the fine semiconductor particles having a large particle size, e.g. approximately 100 to 300 nm in diameter, may be used for the photosensitive layer.

Two or more kinds of the fine semiconductor particles may be used in combination for the photosensitive layer. In this case, one is preferably TiO₂, ZnO, Nb₂O₅ or SrTiO₃ and the other is preferably SnO₂, Fe₂O₃ or WO₃. More preferred combinations are ZnO and SnO₂, ZnO and WO₃, ZnO and SnO₂ and WO₃, etc. When two or more fine semiconductor particles are combined, their particle sizes may differ. Particularly preferable is a combination of larger-diameter particles of TiO₂, ZnO, Nb₂O₅ or SrTiO₃ and smaller-diameter particles of SnO₂, Fe₂O₃ or WO₃. The larger-diameter particles are preferably 100 nm or more in an average size, while the smaller-diameter particles are preferably 15 nm or less in an average size.

Preferably usable as a method for producing the fine semiconductor particles are sol-gel methods described in Sumio Sakka, "Science of Sol-Gel Method," issued by Agune Shofusha (1998), and "Thin Film-Coating Technology by Sol-Gel Method" (1995) issued by the Technical Information Association; and gel-sol methods described in Tadao Sugimoto, "Synthesis of Mono-Dispersion Particles and Control of Their Size and Form by Novel Gel-Sol Method," and MATERIA, Vol. 35, No. 9, pages 1012 to 1018 (1996). Also preferable is a method developed by Degussa, which comprises preparing oxides by subjecting chlorides to a high-temperature hydrolysis in an oxyhydrogen salt.

In the case of using the fine semiconductor particles of titanium oxide, any of the above-described sol-gel methods, gel-sol methods and high-temperature hydrolysis method are preferably used, and a sulfuric acid method and a chlorine method described in Manabu Seino, "Titanium oxide - Properties and Applied Technologies," issued by Gihodo Shuppan, (1997) may also be used. Further preferable as the sol-gel method are those described in Christophe J. Barb'e, et al, the Journal of American Ceramic Society, Vol. 80, No. 12, pages 3157 to 3171 (1997), and Burnside, et al, Chemistry of Materials, Vol. 10, No. 9, pages 2419 to 2425.

### (2) Layer of fine semiconductor particles

The fine semiconductor particles may be applied onto the conductive support by a method for coating a conductive support with a dispersion or a colloidal solution containing fine semiconductor particles, in addition to the above-mentioned sol-gel method. A wet-type film production method is relatively advantageous for the mass production of the photoelectric conversion device, the properties of a liquid containing fine semiconductor particles, the feasibility of conductive supports, etc. Typical examples of such a wet-type film production method are a coating method, a printing method, an electrolytic deposition method and an electrodeposition method. Further, the layer of fine semiconductor particles may be formed by a metal oxidation method, an LPD method for precipitating a metal from a metal solution by ligand exchange, a sputtering method, a vapor deposition method, a CVD method, or an SPD method for forming a metal oxide by thermally decomposing a metal oxide precursor sprayed onto a heated substrate.

The dispersion containing fine semiconductor particles may be prepared by crushing the semiconductor in a mortar, by dispersing the semiconductor while grinding in a mill, or by synthesizing and precipitating the fine semiconductor particles in a reaction solvent, etc. in addition to the above-mentioned sol-gel method.

Usable as dispersion solvents are water or organic solvents such as methanol, ethanol, isopropyl alcohol, citronellol, terpineol, dichloromethane, acetone, acetonitrile, ethyl acetate, etc. A Polymer such as polyethylene glycol, hydroxyethylcellulose and carboxymethylcellulose, a surfactant, an acid, a chelating agent, etc. may be used as a dispersing agent, if necessary. Polyethylene glycol is preferably added to the dispersion, because changing the molecular weight of polyethylene glycol makes it possible to control the viscosity of the dispersion and the porosity of the resultant layer of fine semiconductor particles, and form a layer of fine semiconductor particles resistant to peeling.

Preferred coating methods include application methods such as a roller-coating method and a dipping method, metering methods such as an air-knife method and a blade method, etc. Further, preferable methods for carrying out application and metering in the same portion are a wire-bar method disclosed in JP 58-4589 B, a slide-hopper method described in United States Patents 2,681,294, 2,761,419 and 2,761,791, an extrusion method, a curtain method, etc. Further preferable as commonly usable methods are a spin-coating method and a spraying method. Selectable as wet printing methods are three major printing methods by relief printing, offset printing and gravure printing, as well as an intaglio printing method, a gum printing method, a screen printing method, etc. A film production method may be selected from these methods depending on the viscosity of the dispersion and the desired wet thickness.

The layer of fine semiconductor particles is not limited to a single layer. Dispersions comprising fine semiconductor particles having different particle sizes may be coated to form a multi-layer. Alternatively, dispersions containing different fine semiconductor particles, binders or additives may be coated to form a multi-layer. The multi-layer coating is effective, when it is impossible to form a layer having a sufficient thickness by one coating step.

Generally, the thicker the layer of fine semiconductor particles (having an equal thickness to that of the photosensitive layer), the higher the light-capturing rate, because a larger amount of dye is incorporated therein per a unit-projected area. In this case, however, there is large loss owing to recombination of the electric charges because of increased diffusion distance of the generated electrons. Thus, the preferable thickness of the layer of fine semiconductor particles is 0.1 to 100 µm. In the photoelectric cell, the thickness of the layer of fine semiconductor particles is preferably 1 to 30 µm, more preferably 2 to 25 µm. The amount of fine semiconductor particles applied to the substrate is preferably 0.5 to 100 g, more preferably 3 to 50 g, per 1 m² of the substrate.

After applying the fine semiconductor particles to the conductive support, the fine semiconductor particles are preferably subjected to a heat treatment, thereby bringing them into electronic contact with each other, and increasing the strength of the resultant coating and their adhesion to the support. The heating temperature is preferably 40 to 700°C, more preferably 100 to 600°C. The heating time is preferably 10 minutes to 10 hours. High-temperature treatment is not preferable to a substrate having low melting point or softening point, such as a polymer film substrate, because it tends to deteriorate such a substrate. The heat treatment is preferably carried out at as low a temperature as possible, for example, 50 to 350°C, from the viewpoint of cost. Such a low-temperature heat treatment can be made possible by using a layer containing as fine semiconductor particles as 5 nm or less in average size, a mineral acid, a metal oxide precursor, etc. Further, the heat treatment may be carried out while applying an ultraviolet ray, an infrared ray, a microwave, an electric field, an ultrasonic wave, etc. to the fine semiconductor particles, to lower the heating temperature. To remove unnecessary organic compounds, etc., the heat treatment is preferably carried out in combination with evacuation, an oxygen plasma treatment, and washing with pure water, a solvent or a gas, etc.

After the heat treatment, the layer of fine semiconductor particles may be subjected to chemical metal plating using an aqueous titanium tetrachloride solution, etc. or electrochemical metal plating using an aqueous titanium trichloride solution, etc., to increase the surface area and purity of the fine semiconductor particles, thereby improving the efficiency of injecting electrons into the fine semiconductor particles from the dye. Further, to prevent reverse current from the fine semiconductor particles to the charge transfer layer, it is effective for the fine semiconductor particles to adsorb other low-electron conductivity organic compounds than the dye. The organic compound adsorbed preferably has a hydrophobic group.

The layer of fine semiconductor particles preferably has a large surface area to adsorb a large amount of dye. The layer of fine semiconductor particles coated onto the substrate has a surface area of preferably 10 times or more, more preferably 100 times or more, as its projected area. The upper limit of the surface area is generally about 1000 times, though it is not particularly limited.

### (3) Dye

Any compound capable of absorbing visible and near infrared rays to sensitize the semiconductor may be used as the dye for the photosensitive layer. Preferable examples of such dyes include metal complex dyes, methine dyes, porphyrin-type dyes and phthalocyanine dyes, and the metal complex dyes are particularly preferable. Two or more kinds of dyes may be used in combination to obtain a large photoelectric conversion wavelength region and high photoelectric conversion efficiency. In the case of using a plurality of dyes, the kinds and mixing ratios of the dyes may be determined depending on the wavelength region and strength distribution of the light source.

The dye preferably has an appropriate interlocking group for having interaction with the surfaces of the fine semiconductor particles. Preferred interlocking groups include acidic groups such as -COOH, -OH, - SO₃H, -P(O)(OH)₂ and -OP(O)(OH)₂, and π-conductive chelating groups such as oxime, dioxime, hydroxyquinoline, salicylate and α-ketoenolate groups. Particularly preferable among them are -COOH, -P(O)(OH)₂ and -OP(O)(OH)₂. The interlocking group may form a salt with an alkali metal, etc. or an intramolecular salt. If the methine chain of the polymethine dye has an acidic group, like a case where the methine chain forms a squarylium ring or a croconium ring, the acidic group may act as an interlocking group.

The preferred dyes for the photosensitive layer are specifically described below.

### (a) Metal complex dyes

When the dye is a metal complex dye, the dye is preferably a metallophthalocyanine dye, a metalloporphyrin dye or a ruthenium complex dye, and it is particularly a ruthenium complex dye. The ruthenium complex dyes described in United States Patents 4,927,721, 4,684,537, 5,084,365, 5,350,644, 5,463,057 and 5,525,440, JP 7-249790 A, JP 10-504512 A and JP 2000-26487 A, WO 98/50393, etc. may be used in the present invention.

The ruthenium complex dye is preferably represented by the following formula (V):

(A₁)ₚRu(B-a)(B-b)(B-c) (V),

wherein A₁ represents a unidentate or bidentate ligand, preferably selected from the group consisting of Cl, SCN, H₂O, Br, I, CN, NCO, SeCN, a β-diketone derivative, an oxalate derivative and a dithiocarbamate derivative; *p* is an integer of 0 to 3; and B-a, B-b and B-c are independently organic ligands represented by the following formulae B-1 to B-10.

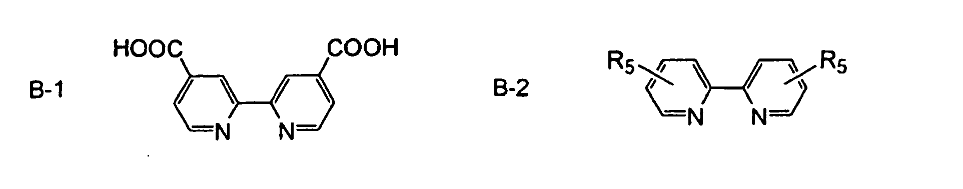

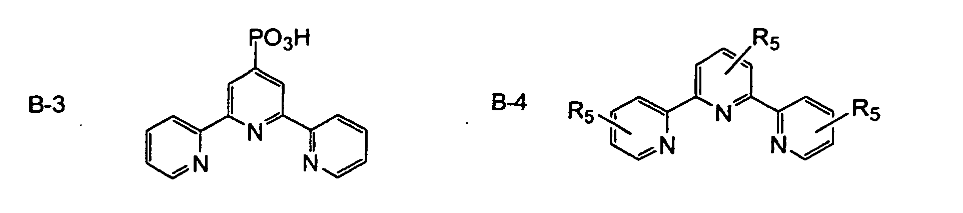

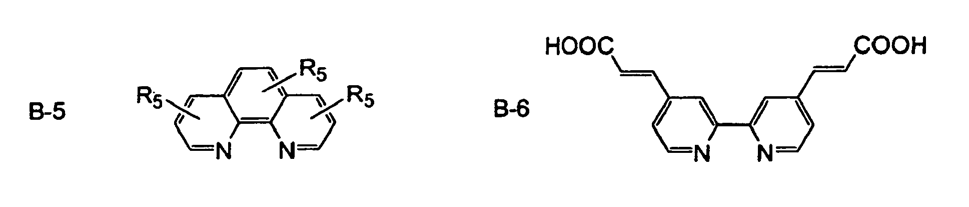

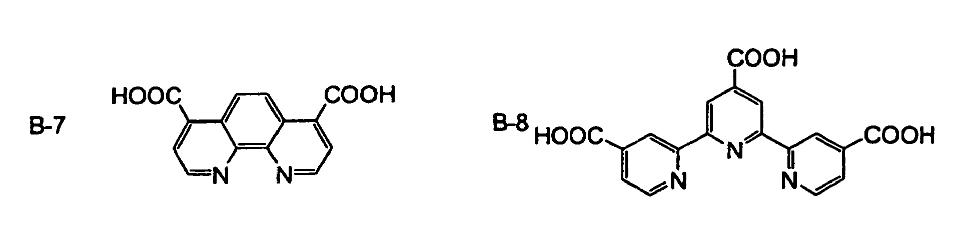

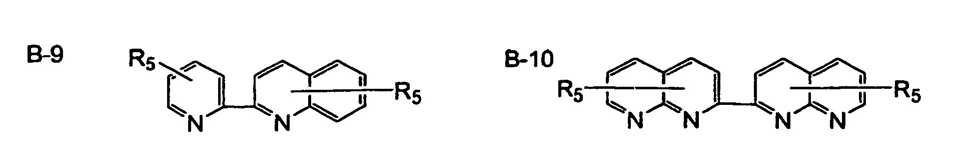

In the formulae B-1 to B-10, R₅ represents a hydrogen atom or a substituent. Specific examples of such substituents include a halogen atom, substituted or unsubstituted alkyl groups having 1 to 12 carbon atoms, substituted or unsubstituted aralkyl groups, having 7 to 12 carbon atoms, substituted or unsubstituted aryl groups having 6 to 12 carbon atoms, acidic groups described above that may form salts, chelating groups etc. The alkyl group and an alkyl moiety of the aralkyl group may be straight or branched, and the aryl group and an aryl moiety of the aralkyl group may have a monocyclic or polycyclic structure such as a condensed ring and a ring assembly. B-a, B-b and B-c may be the same or different, and one or two of them may exist.

Preferred examples of the metal complex dyes are illustrated below without intention of restriction.

(A₁)ₚRu(B-a)(B-b)(B-c) (V),

| R | A₁ | p | B-a | B-b | B-c | R₅ |
|---|---|---|---|---|---|---|
| R-1 | SCN | 2 | B-1 | B-1 | - | - |
| R-2 | CN | 2 | B-1 | B-1 | - | - |
| R-3 | Cl | 2 | B-1 | B-1 | - | - |
| R-4 | CN | 2 | B-7 | B-7 | - | - |
| R-5 | SCN | 2 | B-7 | B-7 | - | - |
| R-6 | SCN | 2 | B-1 | B-2 | - | H |
| R-7 | SCN | 1 | B-1 | B-3 | - | - |
| R-8 | Cl | 1 | B-1 | B-4 | - | H |
| R-9 | I | 2 | B-1 | B-5 | - | H |
| R-10 | SCN | 3 | B-8 | - | - | - |
| R-11 | CN | 3 | B-8 | - | - | - |
| R-12 | SCN | 1 | B-2 | B-8 | - | H |
| R-13 | - | 0 | B-1 | B-1 | B-1 | - |

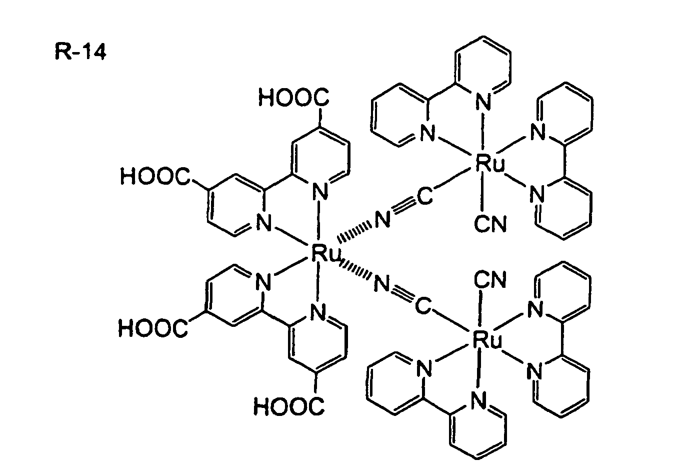

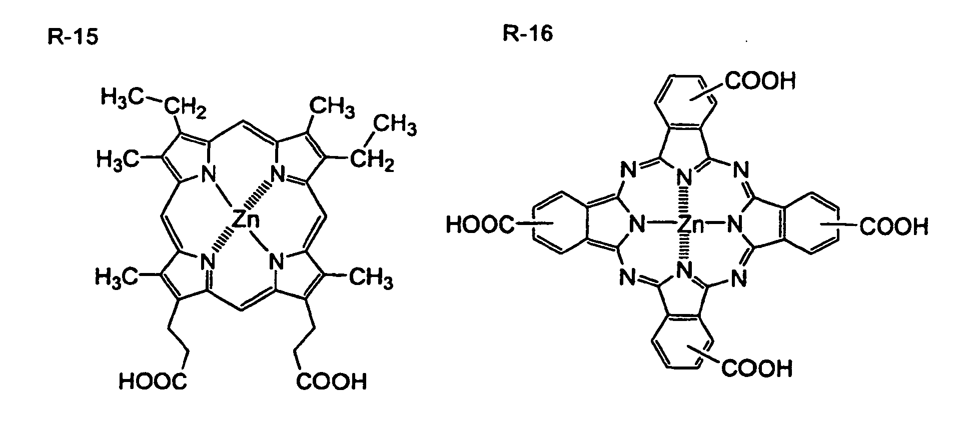

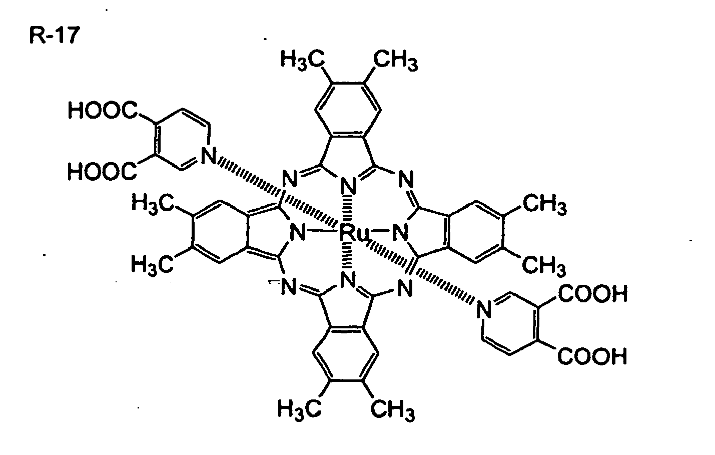

### (b) Methine dyes

The methine dyes usable in the present invention are preferably cyanine dyes, merocyanine dyes or polymethine dyes such as squarylium dyes. Preferable examples of the polymethine dyes usable in the present invention are described in JP 11-35836 A, JP 11-67285 A, JP 11-86916 A, JP 11-97725 A, JP 11-158395 A, JP 11-163378 A, JP 11-214730 A, JP 11-214731 A, JP 11-238905 A and JP 2000-26487 A, European Patents 892411, 911841 and 991092. The preferred methine dyes are specifically described below.

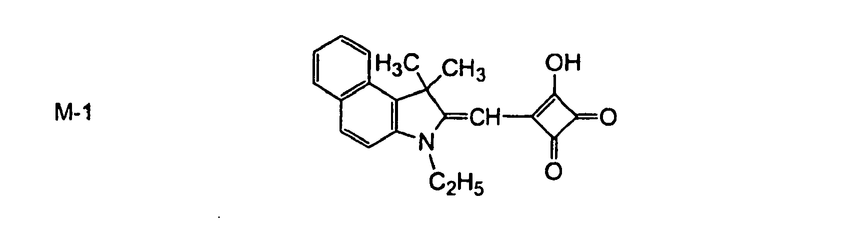

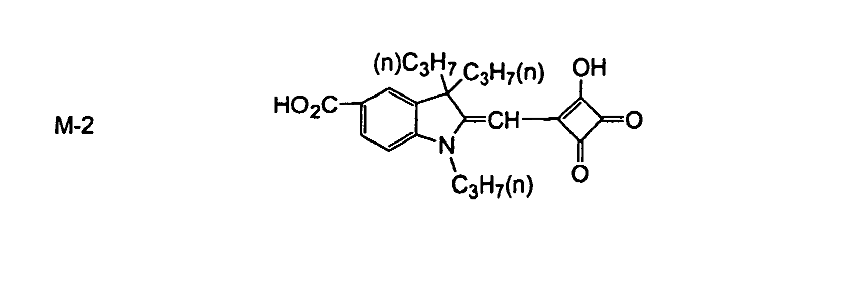

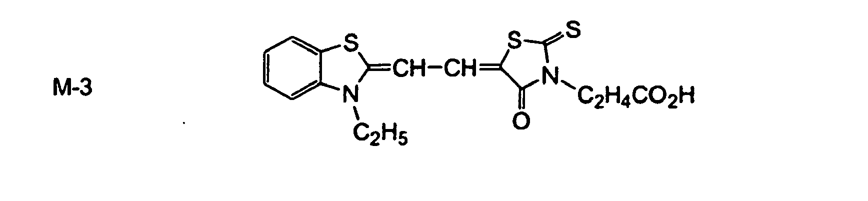

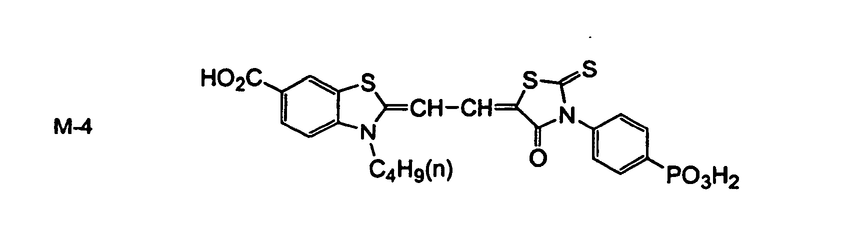

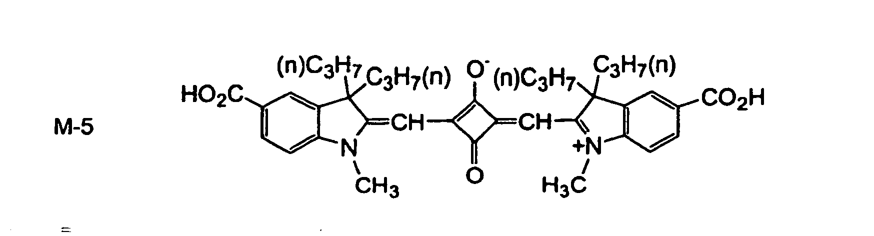

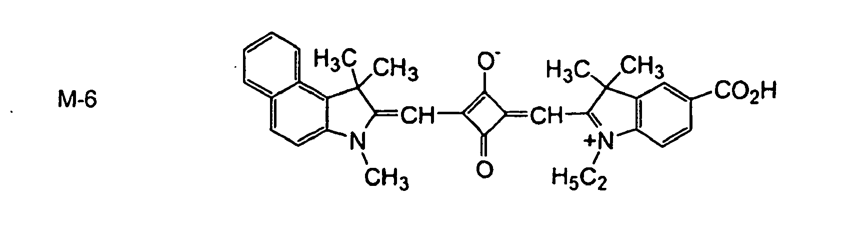

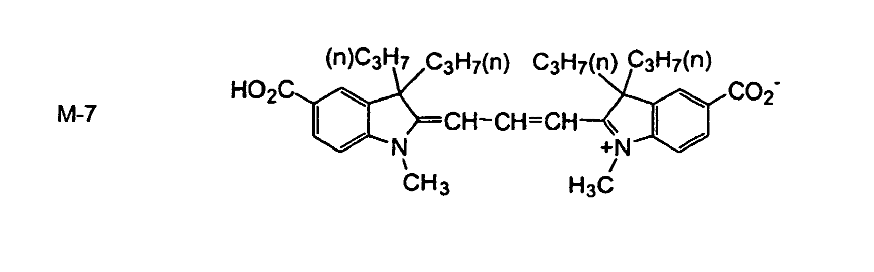

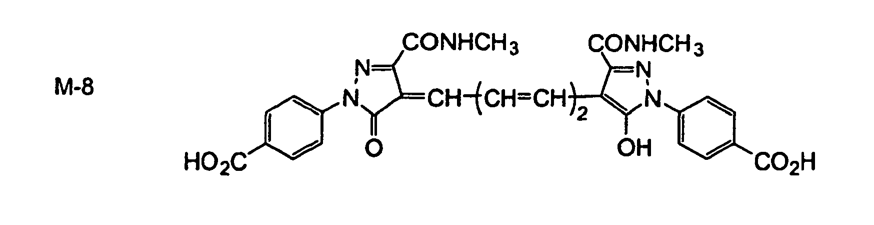

### (4) Adsorption of dye to fine semiconductor particles

The dye may be adsorbed to the fine semiconductor particles by soaking the conductive support having a well-dried layer of fine semiconductor particles in a dye solution, or by coating the dye solution to the layer of fine semiconductor particles. In the former case, a soaking method, a dipping method, a roller-coating method, an air-knife method, etc. may be used. In the soaking method, the dye may be adsorbed at a room temperature or while refluxing as described in JP 7-249790 A. As a coating method of the latter, a wire-bar method, a slide-hopper method, an extrusion method, a curtain method, a spin-coating method, a spraying method, etc. may be used.

Also, pigment may be applied in the form of image to the substrate by an inkjet method, etc., and this image per se may be used as a photoelectric conversion device. Preferable examples of solvents for dissolving the dye include alcohols such as methanol, ethanol, t-butanol and benzyl alcohol; nitriles such as acetonitrile, propionitrile and 3-methoxypropionitrile; nitromethane; halogenated hydrocarbons such as dichloromethane, dichloroethane, chloroform and chlorobenzene; ethers such as diethylether and tetrahydrofuran; dimethylsulfoxide; amides such as *N,N*-dimethylformamide and *N,N*-dimethylacetamide; *N-*methylpyrrolidone; 1,3-dimethylimidazolidinone; 3-methyloxazolidinone; esters such as ethyl acetate and butyl acetate; carbonates such as diethyl carbonate, ethylene carbonate and propylene carbonate; ketones such as acetone, 2-butanone and cyclohexanone; hydrocarbons such as hexane, petroleum ether, benzene and toluene; and mixtures thereof.

The total amount of the dye is preferably 0.01 to 100 mmol per a unit surface area (1 m²) of the porous conductive support. The amount of the dye adsorbed onto the fine semiconductor particles is preferably 0.01 to 1 mmol per 1 g of the fine semiconductor particles. With this adsorption amount of the dye, the semiconductor can be sufficiently sensitized. Too small an amount of the dye results in insufficient sensitization. On the other hand, if the amount of the dye is excessive, the dye not adsorbed onto the fine semiconductor particles is free, thereby reducing the sensitization of the fine semiconductor particles. To increase the adsorption amount of the dye, it is preferable that the layer of fine semiconductor particles is subjected to a heat treatment before the dye is adsorbed thereonto. After the heat treatment, it is preferable for the layer of fine semiconductor particles to quickly adsorb the dye while it is still at 60 to 150°C without returning to room temperature, to prevent water from being adsorbed onto the layer of fine semiconductor particles.

To weaken interaction such as association between the dyes, a colorless compound may be co-adsorbed onto the fine semiconductor particles together with the dye. The colorless compound preferably has surface activity, and examples thereof include steroid compounds having a carboxyl group such as chenodeoxycholic acid and sulfonates shown below.

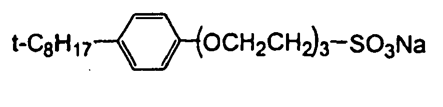

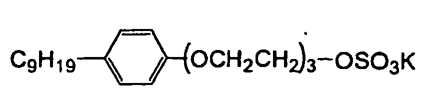

The dye not adsorbed on the layer of fine semiconductor particles is preferably removed by washing immediately after the dye adsorption process. The washing is preferably carried out by a wet-type washing bath with a polar solvent such as acetonitrile or an organic solvent such as alcohol. The surfaces of the fine semiconductor particles may be treated with an amine compound or a quaternary salt thereof after the dye adsorption process. The amine compound is preferably pyridine, 4-*t-*butylpyridine, polyvinylpyridine, etc., and the quaternary salt is preferably tetrabutylammonium iodide, tetrahexylammonium iodide, etc. The amine compound or the quaternary salt may be used alone if it is liquid, or may be used in the form of a solution in an organic solvent.

### (C) Charge transfer layer

The charge transfer layer comprises the electrolytic composition of the present invention described above. The charge transfer layer may be formed by any of the following two methods. One method is to attach a counter electrode to a photosensitive layer beforehand and cause a material for a charge transfer layer in a liquid state to penetrate into a gap therebetween. Another method is to directly form a charge transfer layer on a photosensitive layer, and then form a counter electrode thereon.

In the former method, the material for the charge transfer layer may be made to penetrate into the gap by a normal pressure process utilizing capillarity, or by a reduced pressure process where the material is sucked into the gap to replace a gas phase therein with a liquid phase.

In the case of forming a wet charge transfer layer by the latter method, a counter electrode is attached while the charge transfer layer is still wet, to prevent the leakage of a liquid in edge portions. In the case of a gel electrolyte, it is applied in a wet state and solidified by polymerization. In this case, the counter electrode may be attached after drying and solidification. As a method for applying a wet organic hole-transporting material and a gel electrolyte apart from the electrolyte solution, the same methods as those described above for forming a layer of fine semiconductor particles and applying a dye may be used.

In the case of a solid electrolyte and a solid hole transporting material, the charge transfer layer may be formed by a dry film-forming method such as a vacuum deposition method and a CVD method, and followed by disposing the counter electrode thereon. The organic hole-transporting material may be made to penetrate into the photosensitive layer by a vacuum deposition method, a casting method, a coating method, a spin-coating method, a soaking method, an electrolytic polymerization method, a photo-polymerization method, etc. The inorganic hole-transporting material may be made to penetrate into the photosensitive layer by a casting method, a coating method, a spin-coating method, a soaking method, an electrolytic deposition method, an electroless deposition method, etc.

The water content of the charge transfer layer is preferably 10,000 ppm or less, more preferably 2,000 ppm or less, and particularly 100 ppm or less.

### (D) Counter electrode

Like the above conductive support, the counter electrode may be an electrically conductive layer alone or a laminate of the electrically conductive layer and the substrate. Examples of electrically conductive materials used for the counter electrode include metals such as platinum, gold, silver, copper, aluminum, magnesium and indium; carbon; and electrically conductive metal oxides such as indium-tin composite oxides and fluorine-doped tin oxides. Preferable among them are platinum, gold, silver, copper, aluminum and magnesium. The substrate for the counter electrode is preferably a glass or plastic plate, to which the above electrically conductive material is applied by coating or vapor deposition. The counter electrode layer preferably has a thickness of 3 nm to 10 µm, although the thickness is not particularly limited. The surface resistance of the counter electrode layer is desirably as low as possible. The surface resistance is preferably 50 Ω/square or less, more preferably 20 Ω/square or less.

Because light may be irradiated from either one or both sides of the conductive support and the counter electrode, at least one of them should be substantially transparent to enable light to reach the photosensitive layer. To improve the efficiency of power generation, it is preferable that the conductive support is substantially transparent to permit light to pass therethrough. In this case, the counter electrode is preferably reflective to light. Such a counter electrode may be a glass or plastic plate vapor-deposited with a metal or an electrically conductive oxide, or a thin metal film.

The counter electrode may be formed by coating, plating or vapor-deposition (PVD, CVD, etc.) of an electrically conductive material directly onto the charge transfer layer, or by attaching the electrically conductive layer formed on the substrate to the charge transfer layer. Like in the conductive support, it is preferable to use a metal lead to reduce the resistance of the counter electrode, particularly when the counter electrode is transparent. Preferable materials and formation method of the metal lead, decrease in the amount of incident light, etc. are the same as in the counter electrode.

### (E) Other layers

A thin, dense semiconductor film is preferably formed as an undercoating layer between the conductive support and the photosensitive layer, to prevent short-circuiting between the counter electrode and the conductive support. The prevention of short-circuiting by this undercoating layer is effective particularly in the case of the charge transfer layer composed of the electron-transporting material or the hole-transporting material. The undercoating layer is made of preferably TiO₂, SnO₂, Fe₂O₃, WO₃, ZnO or Nb₂O₅, more preferably TiO₂. The undercoating layer may be formed by a spray-pyrolysis method described in Electrochim. Acta, 40, 643 to 652 (1995), a sputtering method, etc. The thickness of the undercoating layer is preferably 5 to 1000 nm, more preferably 10 to 500 nm.

Functional layers such as a protective layer and a reflection-preventing layer may be formed on either one or both of the conductive support and the counter electrode acting as electrodes, between the electrically conductive layer and the substrate, or in the substrate. The functional layers may be formed by a coating method, a vapor deposition method, an attaching method, etc. depending on their materials.

### (F) Interior structure of photoelectric conversion device

As described above, the photoelectric conversion device may have various interior structures depending on its use. It is classified into two major structures, one allowing light incidence from both sides, and another allowing it from only one side. Figs. 2 to 9 illustrate the interior structures of the photoelectric conversion device, to which the present invention is preferably applicable.

In the structure illustrated in Fig. 2, a photosensitive layer 20 and a charge transfer layer 30 are formed between a transparent electrically conductive layer 10a and a transparent counter electrode layer 40a. This structure allows light incidence from both sides of the device.

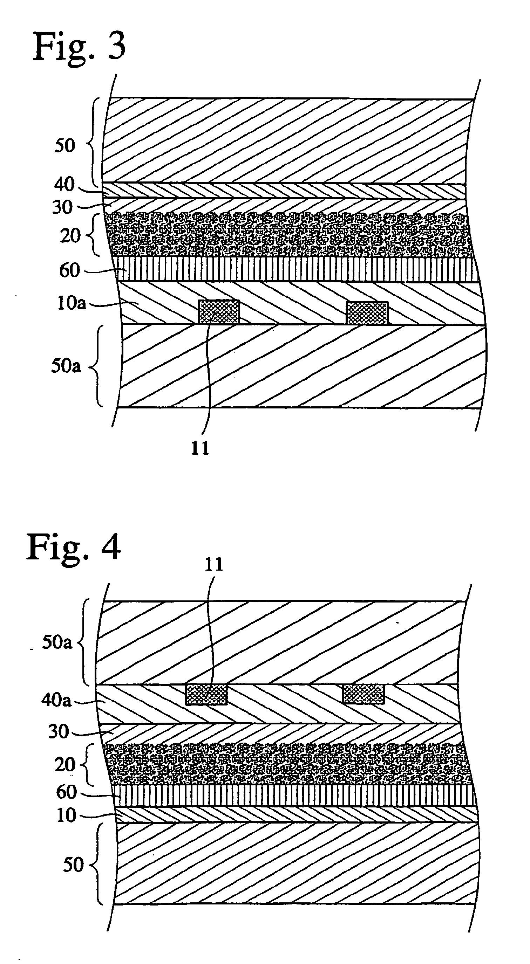

In the structure illustrated in Fig. 3, a transparent substrate 50a partially having a metal lead 11 is provided with an electrically conductive, transparent layer 10a, an undercoating layer 60, a photosensitive layer 20, a charge transfer layer 30 and a counter electrode layer 40 in this order, and further provided with a substrate 50 thereon. This structure allows light incidence from the side of the electrically conductive layer.

In the structure illustrated in Fig. 4, a substrate 50 having an electrically conductive layer 10 is provided with a photosensitive layer 20 via an undercoating layer 60, and then provided with a charge transfer layer 30 and a transparent counter electrode layer 40a thereon, and further provided with a transparent substrate 50a locally having a metal lead 11 with the metal lead 11 inside. This structure allows light incidence from the side of the counter electrode.

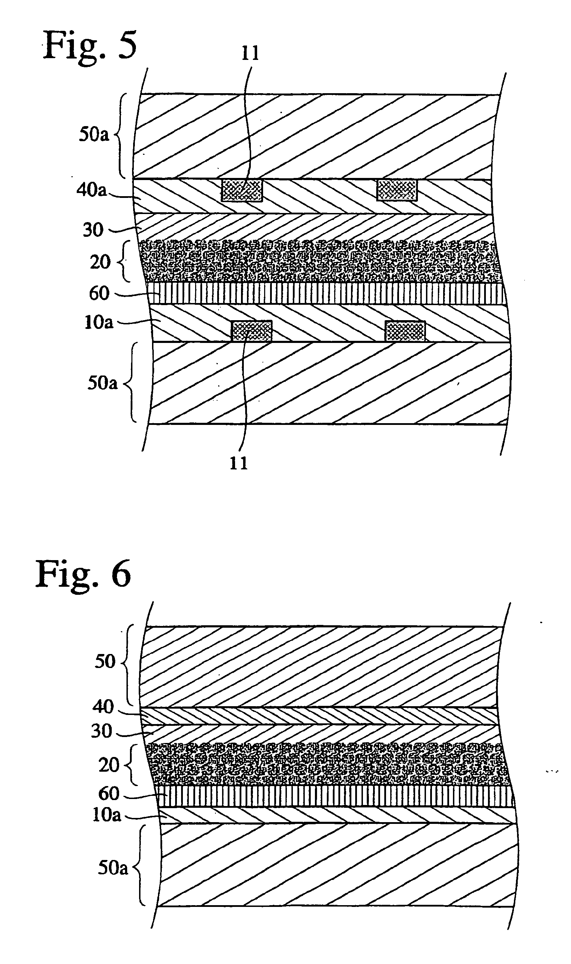

In the structure illustrated in Fig. 5, two transparent substrates 50a each partially having a metal lead 11 are provided with an electrically conductive transparent layer 10a or 40a, and then provided with an undercoating layer 60, a photosensitive layer 20 and a charge transfer layer 30 between the conductive layers. This structure allows light incidence from both sides of the photoelectric conversion device.

In the structure illustrated in Fig. 6, a transparent substrate 50a is provided with an electrically conductive transparent layer 10a, an undercoating layer 60, a photosensitive layer 20, a charge transfer layer 30 and a counter electrode layer 40 in this order, and then attached to a substrate 50. This structure allows light incidence from the side of the electrically conductive layer.

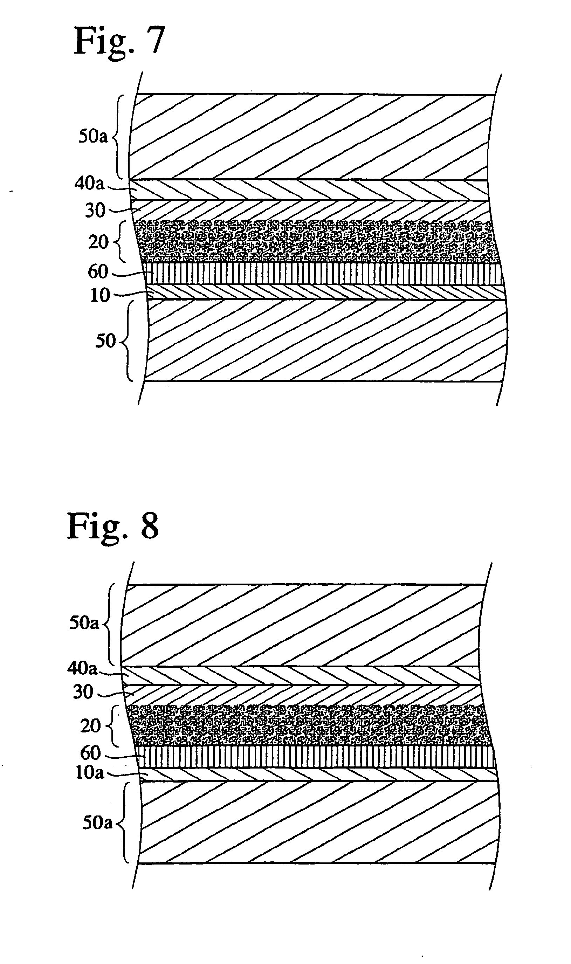

In the structure illustrated in Fig. 7, a substrate 50 is provided with an electrically conductive layer 10, an undercoating layer 60, a photosensitive layer 20, a charge transfer layer 30 and a transparent counter electrode layer 40a in this order, and then attached to a transparent substrate 50a. This structure allows light incidence from the side of the counter electrode.

In the structure illustrated in Fig. 8, a transparent substrate 50a is provided with an electrically conductive transparent layer 10a, a undercoating layer 60, a photosensitive layer 20, a charge transfer layer 30 and a transparent counter electrode layer 40a in this order, and then attached to a transparent substrate 50a. This structure allows light incidence from both sides of the photoelectric conversion device.

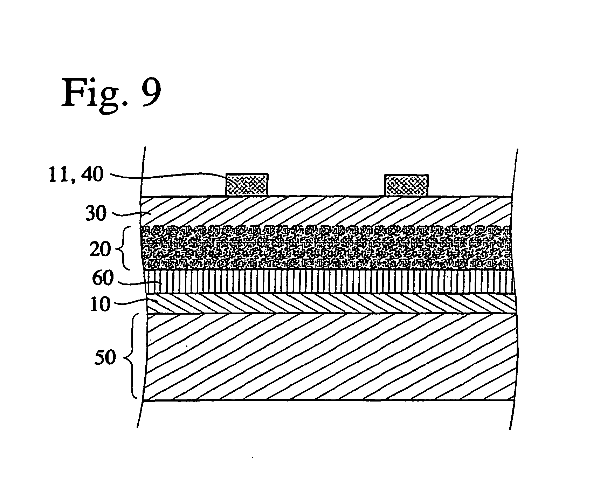

In the structure illustrated in Fig. 9, a substrate 50 is provided with an electrically conductive layer 10, an undercoating layer 60, a photosensitive layer 20, a solid charge transfer layer 30 in this order, and then partially provided with a counter electrode layer 40 or a metal lead 11. This structure allows light incidence from the side of the counter electrode.

### [3] Photo-electrochemical cell

The photo-electrochemical cell of the present invention comprises the above photoelectric conversion device of the present invention to do job in an external circuit. The photo-electrochemical cell for generating power with solar light is referred to as a solar cell.

The sides of the photo-electrochemical cell are preferably sealed with a polymer or an adhesive, etc. to prevent the cell content from deteriorating and evaporating. A known external circuit may be connected to the conductive support and the counter electrode via a lead.

When the photoelectric conversion device of the present invention is used for a solar cell, the interior structure of the solar cell may be essentially the same as that of the photoelectric conversion device mentioned above. The solar cell comprising the photoelectric conversion device of the present invention may have a known module structure. In a general module structure of the solar cell, a cell is disposed on a substrate of metal, ceramic, etc. and covered with a packing resin, a protective glass, etc., whereby light is introduced from the opposite side of the substrate. The solar cell module may have a structure in which the cell is placed on a substrate of a transparent material such as tempered glass to introduce light from the transparent substrate side. Specifically, a super straight-type module structure, a substrate-type module structure, a potting-type module structure, substrate-integrated-type module structure that is generally used in amorphous silicon solar cells, etc. are known as the solar cell module structure. The dye-sensitive solar cell of the present invention may have a module structure properly selected from the above structures depending on ends, locations and environment where it is used, and preferably has a module structure disclosed in JP 2000-268892 A.

The present invention will be explained in more detail with reference to Examples below without intention of restricting the scope of the present invention.

### Example 1

### 1. Syntheses of zwitterionic-type organic salt

The zwitterionic-type organic salts used in the electrolytic composition were synthesized as follows. The structure of each synthesized zwitterionic-type organic salt was identified by NMR and MS spectra.

### (A) Synthesis of D- 1

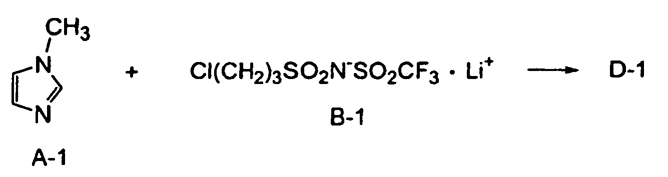

0.4 g of Compound A-1 and 1.5 g of Compound B-1 were dissolved in 10 ml of acetonitrile and reacted under heated reflux for 8 hours. The resultant reaction product was concentrated under a reduced pressure, and dichloromethane was added to remove undissolved lithium chloride. Thereafter, it was purified by a silica gel column chromatography (eluent: methanol/dichloromethane) to obtain 1.1 g of Compound D-1. The MS spectra of the resultant Compound D-1 revealed M⁺(posi) = 335. Compound D-1 had a viscosity Cp(25°C) of 990.

### (B) Synthesis of D-2

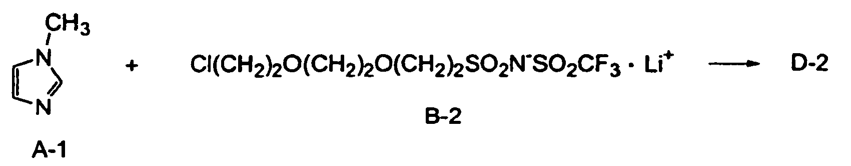

0.4 g of Compound A-1 and 2.5 g of Compound B-2 were dissolved in 10 ml of acetonitrile and reacted under heated reflux for 8 hours. The resultant reaction product was concentrated under a reduced pressure, and dichloromethane was added to remove undissolved lithium chloride. Thereafter, it was purified by a silica gel column chromatography (eluent: methanol/dichloromethane) to obtain 0.9 g of Compound D-2. The MS spectra of the resultant Compound D-2 revealed M⁺(posi) = 409. Compound D-2 had a viscosity Cp(25°C) of 1680.

### (C) Synthesis of D- 18

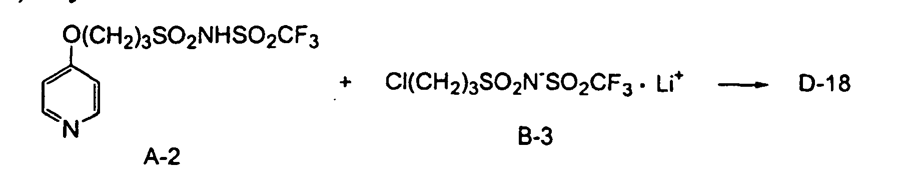

0.4 g of Compound A-1 and 3.5 g of Compound B-2 were dissolved in 20 ml of acetonitrile and reacted under heated reflux for 8 hours. The resultant reaction product was concentrated under a reduced pressure, and dichloromethane was added to remove undissolved lithium chloride. Thereafter, with a solution of tetrabutylammonium in methanol added, it was purified by a silica gel column chromatography (eluent: methanol/dichloromethane) to obtain 0.5 g of Compound D-18. The MS spectra of the resultant Compound D-18 revealed M⁺(posi) = 602. Compound D-18 had a viscosity Cp(25°C) of 3210.

### 2. Production of photo-electrochemical cell

### (A) Preparation of titanium dioxide dispersion

Charged into a 200-ml stainless steel vessel lined with Teflon were 15 g of fine titanium dioxide particles ("Degussa P-25" available from Nippon Aerosil K. K.), 45 g of water, 1 g of a dispersant ("Triton X-100" available from Aldrich), and 30 g of zirconia beads (diameter: 0.5 mm, available from Nikkato K. K.). They were subjected to a dispersion treatment at 1500 rpm for 2 hours by a sand-grinder mill available from Imex K. K. The zirconia beads were removed by filtration to obtain a titanium dioxide dispersion. The average particle diameter of the titanium dioxide particles in the dispersion was 2.5 µm. The particle diameter was measured by Master Sizer available from MALVERN.

### (B) Preparation of dye-adsorbed TiO₂ electrode

The above titanium dioxide dispersion was applied to an electrically conductive glass having a fluorine-doped tin oxide layer (20 mm x 20 mm, "TCO Glass-U" available from Asahi Glass K. K. with a surface resistance of approximately 30 Ω/square) on its conductive surface by a glass bar. The amount of the fine semiconductor particles coated was 20 g/m². With an adhesive tape attached to part of the conductive surface (3 mm from the edge) of each conductive glass as a spacer, eight conductive glasses were arranged such that the adhesive tapes were positioned at both ends, to coat them with the titanium dioxide dispersion simultaneously. After peeling the adhesive tapes, the coated conductive glasses were air-dried at room temperature for a day. Each coated conductive glass was then placed in an electric furnace (muffle furnace "FP-32" available from Yamato Science K. K.), and calcined at 450°C for 30 minutes to obtain a TiO₂ electrode. After the TiO₂ electrode was taken out of the furnace and cooled, the electrode was immersed in a solution of Dye R-1 in ethanol (3 x 10⁻⁴ mol/l) for 3 hours and then in 4-*t*-butylpyridine for 15 minutes. It was then washed with acetonitrile and spontaneously dried to obtain a dye-sensitized TiO₂ electrode substrate.

### (C) Production of photo-electrochemical cell

The above dye-sensitized TiO₂ electrode substrate (20 mm x 20 mm) was laminated on a platinum-vapor-deposited glass having the same size. Next, an electrolytic composition comprising 10% by mass of the following electrolyte salt Y-1, 2% by mass of iodine and 88% by mass of biscyanoethyl ether (BCE) was permeated into the TiO₂ electrode in a gap between the two glasses by capillarity, and sealed with an epoxy-based sealant to obtain a photo-electrochemical cell of Comparative Example 1 having the structure shown in Fig. 1.

In the same as in Comparative Example 1 except for changing electrolytic compositions as shown in Table 1, the photo-electrochemical cells of Examples 1 to 13 and Comparative Examples 2 to 8 were produced. When the electrolytic compositions had such high viscosity that they could not easily be permeated into a gap between the two glasses by capillarity, the electrolytic compositions were heated to 50°C and applied to the TiO₂ electrodes, which were then placed under reduced pressure, so that the electrolytic compositions were fully permeated into the TiO₂ electrodes with air therein removed. Each of them was then laminated with a platinum-vapor-deposited glass (counter electrode). The structure of electrolyte salts Y-1 to Y-4 used in Examples and Comparative Examples are shown in Table 1 below, in which "LiTFSI" represents lithium bis(trifluoromethanesulfonyl)imide.

**Table 1**

| Photo- Electrochemical Cell | Electrolyte Composition Containing 2% by mass of Iodine | |
|---|---|---|
| | Electrolyte Salt (% by mass) | Solvent (% by mass) |
| Comp. Ex. 1 | Y-1 (10) | BCE (88) |
| Comp. Ex. 2 | Y-2 (10) / Y-4 (38) | BCE (50) |
| Comp. Ex. 3 | Y-2 (10) /Y-4 (58) | BCE (30) |
| Comp. Ex. 4 | Y-2 (10) / Y-4 (78) | BCE (10) |
| Comp. Ex. 5 | Y-2 (70) / Y-4 (28) | - |
| Comp. Ex. 6 | D-1 (98) | - |
| Comp. Ex. 7 | Y-3 (70) / D-1 (28) | - |
| Comp. Ex. 8 | LiTFSI (70) / D-1 (28) | - |
| Example 1 | Y-2 (10) / D-1 (10) | BCE (88) |
| Example 2 | Y-2 (10) / D-1 (58) | BCE (30) |
| Example 3 | Y-2 (10) / D-1 (78) | BCE (10) |
| Example 4 | Y-2 (70) / D-1 (28) | - |
| Example 5 | Y-2 (70) / D-2 (28) | - |
| Example 6 | Y-2 (70) / D-3 (28) | - |
| Example 7 | Y-2 (70) / D-4 (28) | - |
| Example 8 | Y-2 (70) / D-5 (28) | - |
| Example 9 | Y-2 (70) / Y-4 (14) / D-1 (14) | - |
| Example 10 | Y-2 (70) / Y-4 (14) / D-2 (14) | - |
| Example 11 | Y-2 (70) / Y-3 (14) / D-1 (14) | - |
| Example 12 | Y-2 (70) / Y-3 (14) / D-2 (14) | - |
| Example 13 | Y-2 (70) / Y-3 (14) / D-12 (14) | - |

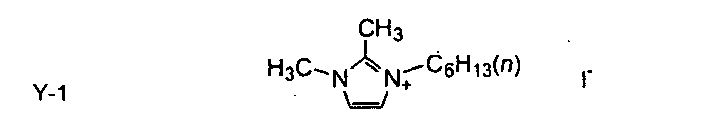

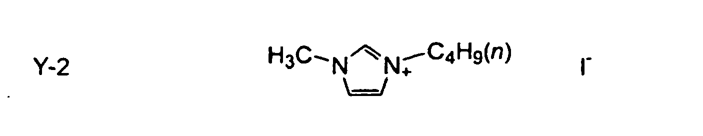

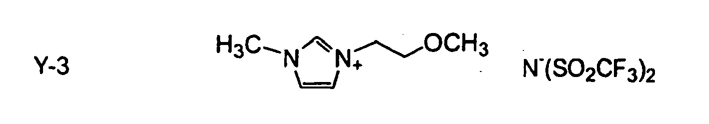

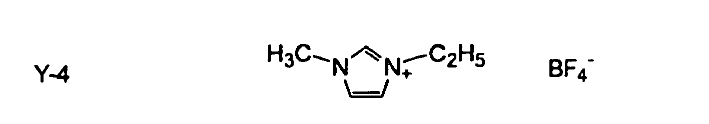

### 3. Measurement of Photoelectric Conversion Efficiency

A light generated by a 500-W xenon lamp (available from Usio Inc.) was caused to pass through an "AM 1.5 filter" available from Oriel and a sharp cut filter "Kenko L-42" to produce a simulated sunlight free from ultraviolet rays. This simulated sunlight had intensity of 100 mW/cm². This simulated sunlight was irradiated onto the photo-electrochemical cells of Examples 1-13 and Comparative Examples 1-8 at 45°C, and electricity generated by each cell was measured by a current-voltage tester "Keithley SMU238", to obtain an open circuit voltage (Voc), a short-circuiting current density (Jsc), a fill factor (FF), a photoelectric conversion efficiency (η), and a decrease ratio (%) of the short-circuiting current density after storage in the dark for 72 hours. The results are shown in Table 2.

**Table 2**

| Photo- Electrochemical Cell | Voc⁽¹⁾ (V) | JSC⁽²⁾ (mA/cm²) | Fill Factor FF | Photoelectric Conversion Efficiency η(%) | Decrease of JSC after 72-Hour Storage (%) |
|---|---|---|---|---|---|
| Comp. Ex. 1 | 0.7 | 12.5 | 0.66 | 5.8 | 88 |
| Comp. Ex. 2 | 0.68 | 8.4 | 0.67 | 3.8 | 54 |
| Comp. Ex. 3 | 0.65 | 8.3 | 0.64 | 3.5 | 38 |
| Comp. Ex. 4 | 0.64 | 8 | 0.62 | 3.2 | 11 |
| Comp. Ex. 5 | 0.65 | 7.2 | 0.59 | 2.8 | 5 |
| Comp. Ex. 6 | 0.21 | 1 | 0.4 | 0.1 | 2 |
| Comp. Ex. 7 | 0.1 | 0.8 | 0.2 | 0.0 | 2 |
| Comp. Ex. 8 | 0.02 | 0.2 | 0.3 | 0.0 | 1 |
| Example 1 | 0.72 | 14.2 | 0.72 | 7.4 | 60 |
| Example 2 | 0.72 | 13.8 | 0.72 | 7.2 | 20 |
| Example 3 | 0.69 | 13.8 | 0.68 | 6.5 | 5 |
| Example 4 | 0.7 | 14.1 | 0.7 | 6.9 | 2 |
| Example 5 | 0.68 | 14.3 | 0.72 | 7.0 | 3 |
| Example 6 | 0.69 | 14.5 | 0.7 | 7.0 | 2 |
| Example 7 | 0.68 | 14 | 0.71 | 6.8 | 2 |
| Example 8 | 0.67 | 14.2 | 0.72 | 6.9 | 1 |
| Example 9 | 0.7 | 14.9 | 0.7 | 7.3 | 3 |
| Example 10 | 0.71 | 15 | 0.71 | 7.6 | 1 |
| Example 11 | 0.72 | 14.8 | 0.7 | 7.5 | 2 |
| Example 12 | 0.7 | 15.1 | 0.7 | 7.4 | 1 |
| Example 13 | 0.7 | 14.5 | 0.68 | 6.9 | 1 |

| | | | | | |
|---|---|---|---|---|---|
| Note (1) Open circuit voltage. (2) Short-circuiting current density. | | | | | |

As shown in Table 2, the short-circuiting current density was remarkably lowered during the storage in the photo-electrochemical cells comprising the electrolytic compositions containing 30% by mass or more of an organic solvent in Comparative Examples 1 to 3 and Examples 1 and 2, while the photo-electrochemical cells of Examples 1 and 2 comprising the electrolytic compositions of the present invention were extremely superior in photoelectric conversion efficiency and durability to those of Comparative Examples 1 and 3 comprising only the conventionally used imidazolium salt. It is also clear from Table 2 that to suppress the decrease of the short-circuiting current density, the solvent content of the electrolytic composition is preferably 10% by mass or less, more preferably zero.

The photo-electrochemical cells of Comparative Examples 4 and 5 comprising only the conventionally used imidazolium salts had a low short-circuiting current density, resulting in low photoelectric conversion efficiency. Substantially no photoelectric conversion was achieved in the photo-electrochemical cell of Comparative Example 6 comprising only an organic salt (I), the photo-electrochemical cell of Comparative Example 7 comprising a combination of the conventional used imidazolium salt and the organic salt (I), and the photo-electrochemical cell of Comparative Example 8 comprising a combination of the known LiTFSI and the organic salt (I). On the other hand, the photo-electrochemical cells of Examples 3 to 13 comprising the electrolytic compositions of the present invention containing the organic salt (I) and the iodine salt exhibited high short-circuiting current density and improved conversion efficiency.

As explained above in detail, the electrolytic composition of the present invention is excellent in the durability and charge-transporting capability. The photoelectric conversion device comprising this electrolytic composition exhibits excellent photoelectric conversion properties suffering from less deterioration of the properties during the long-term use and storage. The photo-electrochemical cell comprising such photoelectric conversion device is remarkably useful as a solar cell.

## Claims

1. An electrolytic composition comprising a zwitterionic-type organic salt and an iodine salt,
wherein said zwitterionic-type organic salt is represented by the following general formula (I): 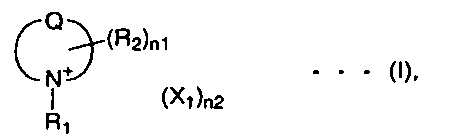 wherein Q represents an atom group forming an aromatic cation having a 5-or 6-membered ring structure with a nitrogen atom; R₁ represents a hydrogen atom or a substituent; R₂ represents a substituent; n1 represents an integer of 0 to 5; X₁ represents a counter ion, n2 represents an integer of 0 to 4; R₂ may be the same or different when n1 is 2 or more; and at least one of R₁ and R₂ is a substituent represented by the following general formula (II):
-L₁-V₁N⁻V₂-R₃ (II)
wherein L₁ represents a divalent group linking the above aromatic cation to V₁ V₁ and V₂ independently represent -CO-, -SO-, -SO₂- or -PO(OR₄)-, wherein R₄ represents an alkyl group or an aryl group; and R₃ represents a substituent.

2. The electrolytic composition according to claim 1, wherein said zwitterionic-type organic salt is liquid at room temperature.

3. The electrolytic composition according to claim 1, wherein said R₁ represents a substituent represented by the general formula (II).

4. The electrolytic composition according to claim 3, wherein at least one of said V₁ and V₂ is -SO₂-.

5. The electrolytic composition according to claim 3 or 4, wherein said n2 is 0.

6. The electrolytic composition according to claim 1, wherein the general formula (I) is represented by the following general formula (III): 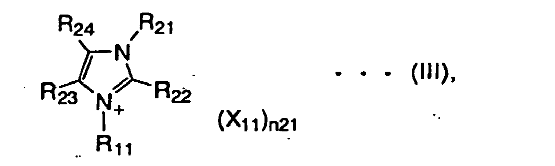 wherein R₁₁ and R₂₁-R₂₄ independently represent a hydrogen atom or a substituent; X₁₁ represents a counter ion; and n21 represents an integer of 0 to 4; R₁₁ and R₂₁-R₂₄ may be the same or different, and at least one of R₁₁ and R₂₁-R₂₄ is a substituent represented by the following general formula (IV):
-L₁₁-V₁₁N⁻V₂₁-R₃₁ (IV),
wherein L₁₁ represents a divalent group linking the imidazolium cation in the general formula (III) to V₁₁; V₁₁ and V₂₁ represent -SO₂-; and R₃₁ represents a substituent.

7. The electrolytic composition according to any one of claims 1 and 3 to 6, wherein the melting point of said zwitterionic-type organic salt is 100°C or lower.

8. The electrolytic composition according to any one of claims 1 to 7, wherein the electrolytic composition comprises iodine.

9. A photoelectric conversion device comprising said electrolytic composition recited in any one of claims 1 to 8.

10. A photo-electrochemical cell comprising said photoelectric conversion device recited in claim 9.

## Patentansprüche

1. Elektrolytzusammensetzung, umfassend ein zwitterionisches organisches Salz und ein Iodsalz, in der das zwitterionische organische Salz durch die folgende allgemeine Formel (I) dargestellt wird: 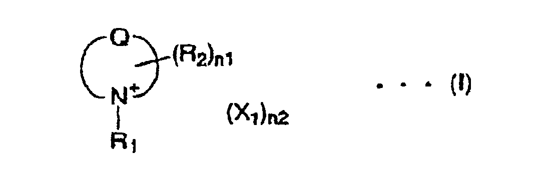 worin Q für eine Atomgruppe steht, die ein aromatisches Kation mit 5- oder 6-gliedriger Ringstruktur mit einem Stickstoffatom bildet; R₁ für ein Wasserstoffatom oder einen Substituenten steht; R₂ für einen Substituenten steht; n1 für eine ganze Zahl von 0 bis 5 steht; X₁ für ein Gegenion steht; n2 für eine ganze Zahl von 0 bis 4 steht; R₂ gleich oder verschieden sein kann, wenn n1 2 oder mehr ist; und mindestens einer der Reste R₁ und R₂ für einen Substituenten der folgenden allgemeinen Formel (II) steht:
-L₁-V₁NV₂-R₃ (II)
worin L₁ für eine zweiwertige Gruppe steht, die das obige aromatische Kation mit V₁ verknüpft; V₁ und V₂ unabhängig voneinander für -CO-, -SO-, -SO₂ oder -PO(OR₄)- stehen, wobei R₄ für eine Alkylgruppe oder eine Arylgruppe steht; und R₃ für einen Substituenten steht.

2. Elektrolytzusammensetzung nach Anspruch 1, in der das zwitterionische organische Salz bei Raumtemperatur flüssig ist.

3. Elektrolytzusammensetzung nach Anspruch 1, in der R₁ für einen Substituenten der allgemeinen Formel (II) steht.

4. Elektrolytzusammensetzung nach Anspruch 3, in der mindestens eine der Gruppen V₁ und V₂ für -SO₂- steht.

5. Elektrolytzusammensetzung nach Anspruch 3 oder 4, in der n2 0 ist.

6. Elektrolytzusammensetzung nach Anspruch 1, in der die allgemeine Formel (I) durch die folgende allgemeine Formel (III) dargestellt wird: 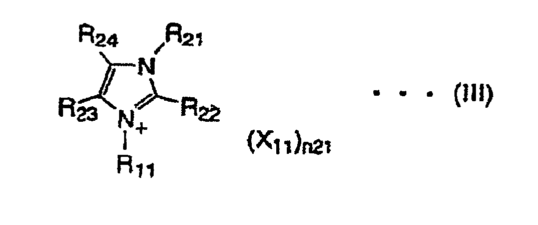 worin R₁₁ und R₂₁-R₂₄ unabhängig voneinander für ein Wasserstoffatom oder einen Substituenten stehen; X₁₁ für ein Gegenion steht und n21 für eine ganze Zahl von 0 bis 4 steht; R₁₁und R₂₁-R₂₄ gleich oder verschieden sein können und mindestens einer der Reste R₁₁ und R₂₁-R₂₄ für einen Substituenten der folgenden allgemeinen Formel (IV) steht:
-L₁₁-V₁₁N⁻V₂₁-R₃₁ (IV)
worin L₁₁ für eine zweiwertige Gruppe steht, die das Imidazoliumkation in der allgemeinen Formel (III) mit V₁₁ verknüpft; V₁₁ und V₂₁ für -SO₂- und R₃₁ für einen Substituenten steht.

7. Elektrolytzusammensetzung nach einem der Ansprüche 1 und 3 bis 6, in der der Schmelzpunkt des zwitterionischen organischen Salzes 100°C oder weniger beträgt.

8. Elektrolytzusammensetzung nach einem der Ansprüche 1 bis 7, umfassend Iod.

9. Photoelektrische Umwandlungsvorrichtung, umfassend die Elektrolytzusammensetzung nach einem der Ansprüche 1 bis 8.

10. Photoelektrochemische Zelle, umfassend die photoelektrische Umwandlungsvorrichtung nach Anspruch 9.

## Revendications

1. Composition électrolytique comprenant un sel organique de type zwitterionique et un sel d'iode, dans laquelle ledit sel organique de type zwitterionique est représenté par la formule générale (I) suivante : 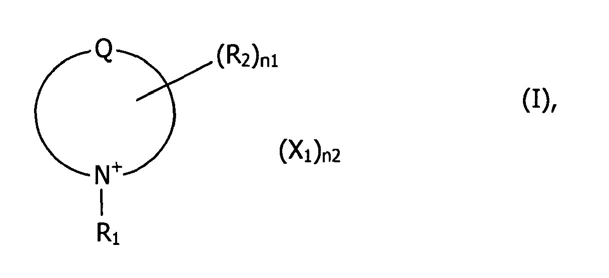 dans laquelle Q représente un groupe d'atomes formant un cation aromatique ayant une structure de cycle à 5 ou 6 éléments avec un atome d'azote ; R₁ représente un atome d'hydrogène ou un substituant ; R₂ représente un substituant ; n1 représente un nombre entier de 0 à 5; X₁ représente un contre-ion, n2 représente un nombre entier de 0 à 4 ; les R₂ peuvent être identiques ou différents lorsque n1 est supérieur ou égal à 2 ; et au moins l'un de R₁ et de R₂ est un substituant représenté par la formule générale (II) suivante :
-L₁ - V₁NV₂ - R₃ (II),
dans laquelle L₁ représente un groupe divalent reliant le cation aromatique ci-dessus à V₁ ; V₁ et V₂ représentent indépendamment -CO-, -SO-, -SO₂- ou -PO(OR₄)-, où R₄ représente un groupe alkyle ou un groupe aryle ; et R₃ représente un substituant.

2. Composition électrolytique selon la revendication 1, dans laquelle ledit sel organique de type zwitterionique est liquide à température ambiante.

3. Composition électrolytique selon la revendication 1, dans laquelle ledit R₁ représente un substituant représenté par la formule générale (II).

4. Composition électrolytique selon la revendication 3, dans laquelle au moins l'un desdits V₁ et V₂ est -SO₂-.

5. Composition électrolytique selon la revendication 3 ou 4, dans laquelle ledit n2 est 0.

6. Composition électrolytique selon la revendication 1, dans laquelle la formule générale (I) est représentée par la formule générale (III) suivante : 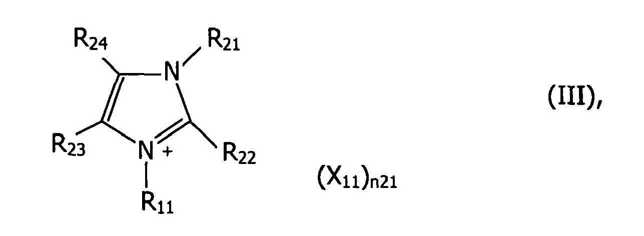 dans laquelle R₁₁ et R₂₁-R₂₄ représentent indépendamment un atome d'hydrogène ou un substituant ; X₁₁ représente un contre-ion ; et n21 représente un nombre entier de 0 à 4 ; R₁₁ et R₂₁-R₂₄ peuvent être identiques ou différents et au moins l'un de R₁₁ et de R₂₁-R₂₄ est un substituant représenté par la formule générale (IV) suivante :
-L₁₁ - V₁₁NV₂₁ - R₃₁ (IV),
dans laquelle L₁₁ représente un groupe divalent reliant le cation imidazolium dans la formule générale (III) à V₁₁ ; V₁₁ et V₂₁ représentent -SO₂- ; et R₃₁ représente un substituant.

7. Composition électrolytique selon l'une quelconque des revendications 1 et 3 à 6, dans laquelle le point de fusion dudit sel organique de type zwitterionique est inférieur ou égal à 100°C.

8. Composition électrolytique selon l'une quelconque des revendications 1 à 7, dans laquelle la composition électrolytique comprend de l'iode.

9. Dispositif de conversion photoélectrique comprenant ladite composition électrolytique selon l'une quelconque des revendications 1 à 8.

10. Pile photoélectrochimique comprenant ledit dispositif de conversion photoélectrique selon la revendication 9.
